# EUROPEAN PATENT APPLICATION

(11) **EP 1 883 010 A2**
(43) Date of publication of application: **30.01.2008**
(21) Application number: 07007520.5
(22) Date of filing: 12.04.2007
(51) Int. Cl.: G06F 3/06

(54) **Virtual disk drive architecture**

(30) Priority: 20.07.2006 US 832537 P; 21.12.2006 US 643132
(71) Applicant: Broadcom Corporation, Irvine, CA 92617 (US)
(72) Inventor: Petikian, Seiran, Irvine, CA 92617 (US); Proano, Jay C., Irvine, CA 92617 (US); Goral, Mark, Irvine, CA 92617 (US); Wiher, Christian R., Irvine, CA 92617 (US); Staal, Frederick Nanoo, Irvine, CA 92617 (US)
(74) Representative: Jehle, Volker Armin

(57) **Abstract**

Virtual disk drive architecture. A novel approach is presented by which a virtual design system allows for the design, development, and testing of memory storage devices including hard disk drives (HDDs). A virtual disk drive architecture allows for the implementation and emulation of a full HDD system. All of the pieces of the HDD system (e.g., including both the read channel and the controller functionalities) are included and implemented to allow a designer to develop and test certain portions within the system. In some embodiments, one or more field programmable gate arrays (FPGAs) are employed to implement a hard drive (HD) controller in an all digital implementation. Various combinations including circuit boards and FPGAs can be employed to emulate an entire HDD system. In even other embodiments, one or more sockets, and appropriate interfacing, are included to allow the testing of actual chips within the virtual disk drive architecture.

## Description

### CROSS REFERENCE TO RELATED PATENTS/PATENT APPLICATIONS

### Provisional priority claims

The present U.S. Utility Patent Application claims priority pursuant to 35 U.S.C. § 119(e) to the following U.S. Provisional Patent Application which is hereby incorporated herein by reference in its entirety and made part of the present U.S. Utility Patent Application for all purposes:
1. U.S. Provisional Application Serial No. 60/832,537, entitled "Virtual disk drive architecture," (Attorney Docket No. BP5527), filed 07/20/2006, pending.

### BACKGROUND OF THE INVENTION

### TECHNICAL FIELD OF THE INVENTION

The invention relates generally to hard disk drives (HDDs); and, more particularly, it relates to apparatus and methods employed within the design of such HDDs.

### DESCRIPTION OF RELATED ART

As is known, many varieties of memory storage devices (e.g. disk drives or HDDs), such as magnetic disk drives are used to provide data storage for a host device, either directly, or through a network such as a storage area network (SAN) or network attached storage (NAS). Typical host devices include stand alone computer systems such as a desktop or laptop computer, enterprise storage devices such as servers, storage arrays such as a redundant array of independent disks (RAID) arrays, storage routers, storage switches and storage directors, and other consumer devices such as video game systems and digital video recorders. These devices provide high storage capacity in a cost effective manner.

In the design of such memory storage devices, there is great challenge and difficulty in testing various components and/or functional blocks therein. For example, certain prior art approaches involve using some form of arbitrary waveform generator (AWG) to provide certain signals to various components and/or functional blocks within a HDD. One such leader in this AWG technology is Tektronix ®, which manufacturers various AWGs for use in design and development of HDDs. However, these AWGs are typically very expensive and have certain performance limitations as well understood in the art (e.g., limited amount of memory, focus primarily only on the read channel functionality, etc.). There has been and continues to be a need in the art for a better means by which HDD and other memory storage devices can be designed in a more efficient, streamlined, and effective manner.

### BRIEF SUMMARY OF THE INVENTION

The present invention is directed to apparatus and methods of operation that are further described in the following Brief Description of the Several Views of the Drawings, the Detailed Description of the Invention, and the claims.

According to an aspect of the invention, a hard disk drive (HDD) design system is provided, the system comprising:
a VHDA (Virtual Hard Disk Assembly) that is operable to simulate operation of at least one of a storage media, a spindle motor, and an arm within a HDD system;
a read channel module that is operable to simulate operation of a read channel within the HDD system;
a controller module that is operable to simulate operation of a controller within the HDD system;
a servo position module that is operable to simulate operation of a servo position system within the HDD system; and
a user interface that is operable to permit modification of at least one operating parameter within the HDD design system.

Advantageously,
the HDD design system is operable to generate servo position system data on the fly in real time.

Advantageously,
at least one of the read channel module and the controller module is implemented, at least in part, within the HDD design system using an integrated circuit.

Advantageously,
at least one of the VHDA, the read channel module, the controller module, and the servo position module is simulated within the HDD design system using a field programmable gate array (FPGA).

Advantageously,
the read channel module is implemented as a read channel integrated circuit within the HDD design system; and
the servo position module is implemented as an actual servo position system within the HDD design system.

Advantageously,
the read channel module is implemented as a read channel integrated circuit within the HDD design system;
the controller module is implemented as a controller integrated circuit within the HDD design system; and
the servo position module is implemented as an actual servo position system within the HDD design system.

Advantageously,
the HDD design system includes a memory buffer that is operable to store simulation data that is generated by at least one of the VHDA, the read channel module, and the controller module.

Advantageously,
the HDD design system includes a memory buffer that is operable to store simulation data that is generated by at least one of the VHDA, the read channel module, and the controller module; and
the memory buffer is operable to store at least 1 Giga-byte of simulation data.

Advantageously,
the user interface includes a computer that is operable to control and monitor operation of at least one of the VHDA, the read channel module, the controller module, and the servo position module.

Advantageously,
the read channel module, the controller module, and the servo position module are implemented as a system on a chip (SoC) module.

According to an aspect of the invention, a hard disk drive (HDD) design system comprises:
a VHDA (Virtual Hard Disk Assembly) that is operable to simulate operation of at least one of a storage media, a spindle motor, a preamp, and an arm within a HDD system;
a read channel module that is operable to simulate operation of a read channel within the HDD system;
a controller module that is operable to simulate operation of a controller within the HDD system;
a servo position module that is operable to simulate operation of a servo position system within the HDD system;
a user interface that is operable to permit modification of at least one simulated or actual component within the HDD design system; and
a memory buffer that is operable to store simulation data that is generated by at least one of the VHDA, the read channel module, and the controller module; and
wherein:
at least one of the read channel module and the controller module is implemented, at least in part, within the HDD design system using an integrated circuit; and
the memory buffer is operable to store at least 1 Giga-byte of simulation data.

Advantageously,
the HDD design system is operable to generate servo position system data on the fly in real time.

Advantageously,
at least one of the VHDA, the read channel module, the controller module, and the servo position module is simulated within the HDD design system using a field programmable gate array (FPGA).

Advantageously,
the servo position module is implemented as an actual servo position system within the HDD design system.

Advantageously,
the user interface includes a computer that is operable to control and monitor operation of at least one of the VHDA, the read channel module, the controller module, and the servo position module.

Advantageously,
the read channel module, the controller module, and the servo position module are implemented as a system on a chip (SoC) module.

According to an aspect of the invention, a method is provided for designing a hard disk drive (HDD) system, the method comprising:
simulating operation of at least one of a storage media, a spindle motor, and an arm within a HDD system;
simulating operation of a read channel within the HDD system;
simulating operation of a controller within the HDD system;
simulating operation of a servo position system within the HDD system;
storing simulation data that is generated when simulating at least one of the storage media, the spindle motor, and the arm within the HDD system, the read channel module, and the controller module; and
controlling at least one operating parameter within the HDD design system via a user interface.

Advantageously, the method further comprises:
generating servo position system data on the fly in real time.

Advantageously,
the storing simulation data that is generated when simulating at least one of the storage media, the spindle motor, and the arm within the HDD system, the read channel module, and the controller module is performed using a memory buffer; and
the memory buffer is operable to store at least 1 Giga-byte of simulation data.

Advantageously, at least one of:
the simulating operation of the read channel is performed using a read channel integrated circuit; and
the simulating operation of the controller is performed using a controller integrated circuit.

Other features and advantages of the present invention will become apparent from the following detailed description of the invention made with reference to the accompanying drawings.

### BRIEF DESCRIPTION OF THE SEVERAL VIEWS OF THE DRAWINGS

FIG. 1 illustrates an embodiment of a disk drive unit.

FIG. 2 illustrates an embodiment of an apparatus that includes a disk controller.

FIG. 3A illustrates an embodiment of a handheld audio unit.

FIG. 3B illustrates an embodiment of a computer.

FIG. 3C illustrates an embodiment of a wireless communication device.

FIG. 3D illustrates an embodiment of a personal digital assistant (PDA).

FIG. 3E illustrates an embodiment of a laptop computer.

FIG. 4 illustrates an embodiment of a system including hard disk drive (HDD).

FIG. 5 illustrates an embodiment of an HDD design system.

FIG. 6 illustrates an embodiment of a HDD system that includes a virtual disk drive.

FIG. 7 illustrates an alternative embodiment of an HDD design system.

FIG. 8 illustrates an embodiment of read and servo event signals.

FIG. 9 illustrates an embodiment of signals employed when operating in on-track and seek modes, respectively.

FIG. 10 illustrates an embodiment of various convolutional signals that are generated by magnetic pulses.

FIG. 11 illustrates an embodiment of a step response based architecture.

FIG. 12 illustrates an embodiment of a pulse response based architecture.

FIG. 13 illustrates an embodiment of a noise and distortion basic model.

FIG. 14 illustrates an embodiment of a first model of transition media noise.

FIG. 15 illustrates an embodiment of a second model of transition media noise.

FIG. 16 illustrates an embodiment of MRA (Magneto-Resistive Asymmetry).

FIG. 17 illustrates an embodiment of thermal asperity.

FIG. 18 illustrates an embodiment of preamp distortion.

FIG. 19 illustrates an embodiment of a DAC/FIR (Digital to Analog Converter/Finite Impulse Response Filter) architecture.

FIG. 20 illustrates an embodiment of a FIR step response architecture.

FIG. 21 illustrates an embodiment of a FIR pulse response architecture.

FIG. 22 illustrates an embodiment of a resistor network architecture.

FIG. 23 illustrates an embodiment of approaches to shaping an output by either a step (transition) response or a pulse response.

FIG. 24 illustrates an embodiment of a FIR implementation in conjunction with a DAC.

FIG. 25 illustrates an embodiment of LUT (Look Up Table) based implementation adapted for HDD systems employing LMR (Longitudinal Magnetic Recording).

FIG. 26, FIG. 27, and FIG. 28 illustrate embodiments, respectively, of the LUT contents as adapted for LMR (e.g., such as illustrated within FIG. 25).

FIG. 29 illustrates an embodiment of LUT (Look Up Table) based implementation adapted for HDD systems employing PMR (Perpendicular Magnetic Recording).

FIG. 30, FIG. 31, and FIG. 32 illustrate embodiments of the LUT contents as adapted for PMR (e.g., such as illustrated within FIG. 29).

FIG. 33 illustrates an embodiment of a resistor network approach.

FIG. 34 illustrates embodiments (variant1 and variant2) of resistor network implementations.

FIG. 35 illustrates an embodiment of a resistor network implementation in conjunction with a field programmable gate array (FPGA).

FIG. 36 illustrates an embodiment of analog convolution for HDD systems employing LMR.

FIG. 37 and FIG. 38 illustrate embodiments of decomposition of an input stream.

FIG. 39 illustrates an embodiment of analog transition response generator and sum.

FIG. 40 illustrates an embodiment of test results for the analog transition response generator and sum of FIG. 39.

FIG. 41 illustrates an embodiment of a spice simulation for the analog transition response generator and sum of FIG. 39.

FIG. 42 illustrates an embodiment of rise and fall correspondence after decomposition. This diagram is an enlarged version of the signal transitions shown as within FIG. 41.

FIG. 43 illustrates another embodiment of test results for the transition response generator and sum of FIG. 39.

FIG. 44 illustrates an embodiment of a method for designing an HDD system.

### DETAILED DESCRIPTION OF THE INVENTION

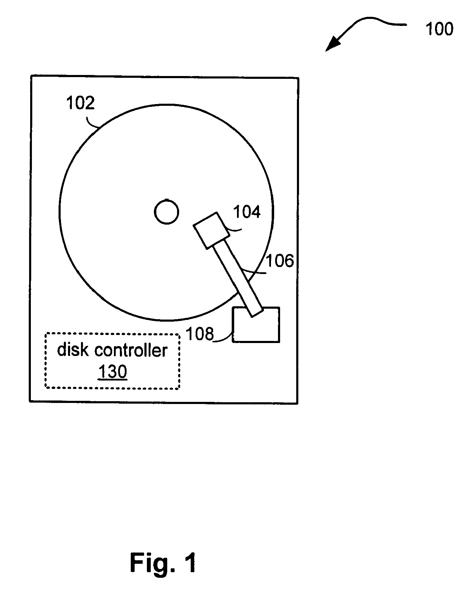

FIG. 1 illustrates an embodiment of a disk drive unit 100. In particular, disk drive unit 100 includes a disk 102 that is rotated by a servo motor (not specifically shown) at a velocity such as 3600 revolutions per minute (RPM), 4200 RPM, 4800 RPM, 5,400 RPM, 7,200 RPM, 10,000 RPM, 15,000 RPM, however, other velocities including greater or lesser velocities may likewise be used, depending on the particular application and implementation in a host device. In one possible embodiment, disk 102 can be a magnetic disk that stores information as magnetic field changes on some type of magnetic medium. The medium can be a rigid or non-rigid, removable or non-removable, that consists of or is coated with magnetic material.

Disk drive unit 100 further includes one or more read/write heads 104 that are coupled to arm 106 that is moved by actuator 108 over the surface of the disk 102 either by translation, rotation or both. A disk controller 130 is included for controlling the read and write operations to and from the drive, for controlling the speed of the servo motor and the motion of actuator 108, and for providing an interface to and from the host device.

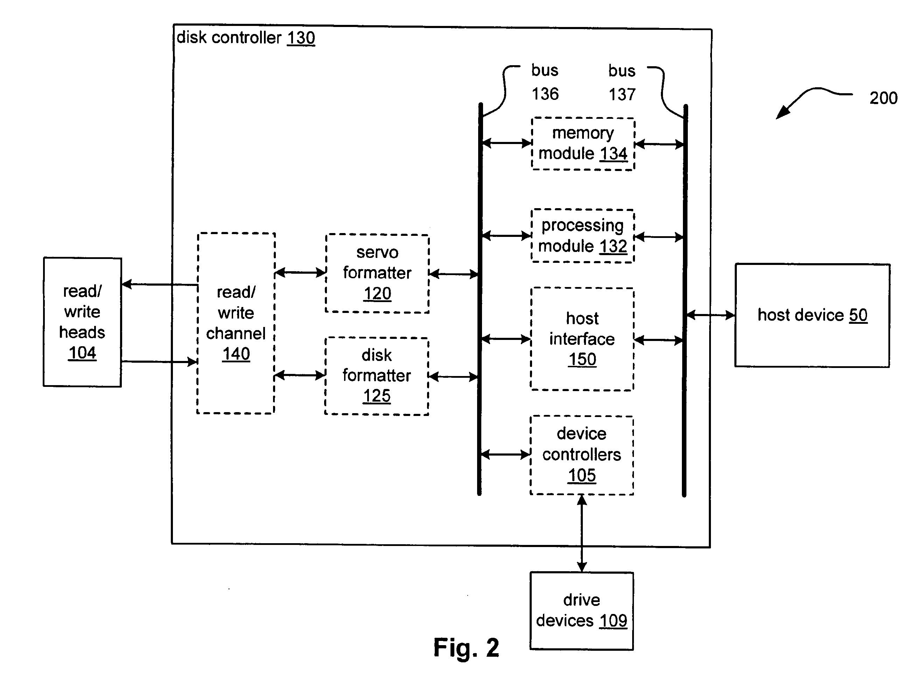

FIG. 2 illustrates an embodiment of an apparatus 200 that includes a disk controller 130. In particular, disk controller 130 includes a read/write channel 140 for reading and writing data to and from disk 102 through read/write heads 104. Disk formatter 125 is included for controlling the formatting of data and provides clock signals and other timing signals that control the flow of the data written to, and data read from disk 102. Servo formatter 120 provides clock signals and other timing signals based on servo control data read from disk 102. Device controllers 105 control the operation of drive devices 109 such as actuator 108 and the servo motor, etc. Host interface 150 receives read and write commands from host device 50 and transmits data read from disk 102 along with other control information in accordance with a host interface protocol. In one embodiment, the host interface protocol can include, SCSI, SATA, enhanced integrated drive electronics (EIDE), or any number of other host interface protocols, either open or proprietary that can be used for this purpose.

Disk controller 130 further includes a processing module 132 and memory module 134. Processing module 132 can be implemented using one or more microprocessors, micro-controllers, digital signal processors, microcomputers, central processing units, field programmable gate arrays, programmable logic devices, state machines, logic circuits, analog circuits, digital circuits, and/or any devices that manipulates signal (analog and/or digital) based on operational instructions that are stored in memory module 134. When processing module 132 is implemented with two or more devices, each device can perform the same steps, processes or functions in order to provide fault tolerance or redundancy. Alternatively, the function, steps and processes performed by processing module 132 can be split between different devices to provide greater computational speed and/or efficiency.

Memory module 134 may be a single memory device or a plurality of memory devices. Such a memory device may be a read-only memory, random access memory, volatile memory, non-volatile memory, static random access memory (SRAM), dynamic random access memory (DRAM), flash memory, cache memory, and/or any device that stores digital information. Note that when the processing module 132 implements one or more of its functions via a state machine, analog circuitry, digital circuitry, and/or logic circuitry, the memory module 134 storing the corresponding operational instructions may be embedded within, or external to, the circuitry comprising the state machine, analog circuitry, digital circuitry, and/or logic circuitry. Further note that, the memory module 134 stores, and the processing module 132 executes, operational instructions that can correspond to one or more of the steps or a process, method and/or function illustrated herein.

Disk controller 130 includes a plurality of modules, in particular, device controllers 105, processing module 132, memory module 134, read/write channel 140, disk formatter 125, servo formatter 120 and host interface 150 that are interconnected via bus 136 and bus 137. Each of these modules can be implemented in hardware, firmware, software or a combination thereof, in accordance with the broad scope of the present invention. While a particular bus architecture is shown in FIG. 2 with buses 136 and 137, alternative bus architectures that include either a single bus configuration or additional data buses, further connectivity, such as direct connectivity between the various modules, are likewise possible to implement the features and functions included in various embodiments.

In one possible embodiment, one or more modules of disk controller 130 are implemented as part of a system on a chip (SoC) integrated circuit. In an embodiment, this SoC integrated circuit includes a digital portion that can include additional modules such as protocol converters, linear block code encoding and decoding modules, etc., and an analog portion that includes device controllers 105 and optionally additional modules, such as a power supply, etc. In a further embodiment, the various functions and features of disk controller 130 are implemented in a plurality of integrated circuit devices that communicate and combine to perform the functionality of disk controller 130.

When the drive unit 100 is manufactured, disk formatter 125 writes a plurality of servo wedges along with a corresponding plurality of servo address marks at equal radial distance along the disk 102. The servo address marks are used by the timing generator for triggering the "start time" for various events employed when accessing the media of the disk 102 through read/write heads 104.

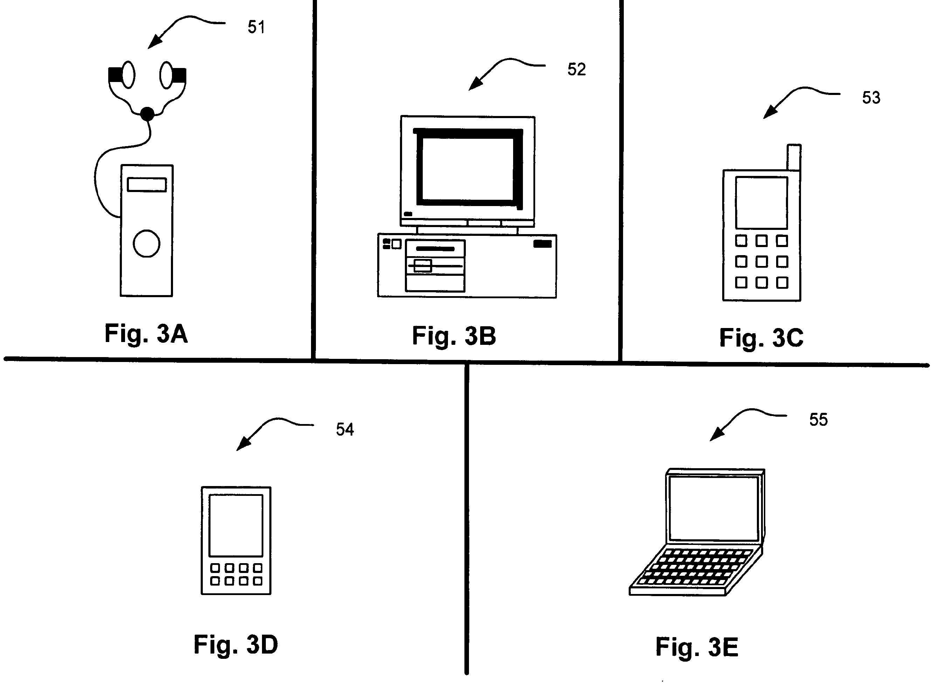

FIG. 3A illustrates an embodiment of a handheld audio unit 51. In particular, disk drive unit 100 can be implemented in the handheld audio unit 51. In one possible embodiment, the disk drive unit 100 can include a small form factor magnetic hard disk whose disk 102 has a diameter 1.8" or smaller that is incorporated into or otherwise used by handheld audio unit 51 to provide general storage or storage of audio content such as motion picture expert group (MPEG) audio layer 3 (MP3) files or Windows Media Architecture (WMA) files, video content such as MPEG4 files for playback to a user, and/or any other type of information that may be stored in a digital format.

FIG. 3B illustrates an embodiment of a computer 52. In particular, disk drive unit 100 can be implemented in the computer 52. In one possible embodiment, disk drive unit 100 can include a small form factor magnetic hard disk whose disk 102 has a diameter 1.8" or smaller, a 2.5" or 3.5" drive or larger drive for applications such as enterprise storage applications. Disk drive 100 is incorporated into or otherwise used by computer 52 to provide general purpose storage for any type of information in digital format. Computer 52 can be a desktop computer, or an enterprise storage devices such a server, of a host computer that is attached to a storage array such as a redundant array of independent disks (RAID) array, storage router, edge router, storage switch and/or storage director.

FIG. 3C illustrates an embodiment of a wireless communication device 53. In particular, disk drive unit 100 can be implemented in the wireless communication device 53. In one possible embodiment, disk drive unit 100 can include a small form factor magnetic hard disk whose disk 102 has a diameter 1.8" or smaller that is incorporated into or otherwise used by wireless communication device 53 to provide general storage or storage of audio content such as motion picture expert group (MPEG) audio layer 3 (MP3) files or Windows Media Architecture (WMA) files, video content such as MPEG4 files, JPEG (joint photographic expert group) files, bitmap files and files stored in other graphics formats that may be captured by an integrated camera or downloaded to the wireless communication device 53, emails, webpage information and other information downloaded from the Internet, address book information, and/or any other type of information that may be stored in a digital format.

In a possible embodiment, wireless communication device 53 is capable of communicating via a wireless telephone network such as a cellular, personal communications service (PCS), general packet radio service (GPRS), global system for mobile communications (GSM), and integrated digital enhanced network (iDEN) or other wireless communications network capable of sending and receiving telephone calls. Further, wireless communication device 53 is capable of communicating via the Internet to access email, download content, access websites, and provide steaming audio and/or video programming. In this fashion, wireless communication device 53 can place and receive telephone calls, text messages such as emails, short message service (SMS) messages, pages and other data messages that can include attachments such as documents, audio files, video files, images and other graphics.

FIG. 3D illustrates an embodiment of a personal digital assistant (PDA) 54. In particular, disk drive unit 100 can be implemented in the personal digital assistant (PDA) 54. In one possible embodiment, disk drive unit 100 can include a small form factor magnetic hard disk whose disk 102 has a diameter 1.8" or smaller that is incorporated into or otherwise used by personal digital assistant 54 to provide general storage or storage of audio content such as motion picture expert group (MPEG) audio layer 3 (MP3) files or Windows Media Architecture (WMA) files, video content such as MPEG4 files, JPEG (joint photographic expert group) files, bitmap files and files stored in other graphics formats, emails, webpage information and other information downloaded from the Internet, address book information, and/or any other type of information that may be stored in a digital format.

FIG. 3E illustrates an embodiment of a laptop computer 55. In particular, disk drive unit 100 can be implemented in the laptop computer 55. In one possible embodiment, disk drive unit 100 can include a small form factor magnetic hard disk whose disk 102 has a diameter 1.8" or smaller, or a 2.5" drive. Disk drive 100 is incorporated into or otherwise used by laptop computer 52 to provide general purpose storage for any type of information in digital format.

As these various embodiments of HDDs and applications in which HDDs are presented above, it is noted that alternative embodiments of HDDs and HDD systems may also be employed. However, regardless of which particular embodiment of HDD is employed or is designed for a particular application or system, there is continually a need to design such HDDs.

Various embodiments of a virtual disk drive are presented herein that allow for a much quicker design, development, and testing of various HDD systems. In some of the embodiments, an actual integrated circuit or other component can be physically inserted within the virtual environment. Using this capability, certain components (e.g., a head disk assembly) can be emulated using circuit boards, digital circuitry such as FPGAs and other emulating means, and even other components (e.g., read channel components) can be implemented within the virtual disk drive using an actual integrated circuit and/or other hardware component. From this point of view, a virtual disk drive that is a hybrid of an actual/simulated HDD system can be emulated (i.e., certain components are actual, and others are simulated).

This virtual disk drive, when viewed as being a test environment, allows for the testing of various components that may be available at different times. For example, when developing an HDD system, multiple integrated circuits and/or components may be employed, and each of those integrated circuits and/or components can then be tested as they become available. At any time, an actual physical component can be tested within the virtual disk drive such that each of the other components within the virtual disk drive is emulated/simulated.

This virtual disk drive architecture can be implemented in a very large scale application. For example, the amount of memory that can be allocated for monitoring and testing purposes significantly exceeds that found within prior art test systems. For example, in some embodiments, a 1 Giga-byte (1 GB) buffer can be implemented and dedicated to gathering certain types of information including data information. In addition, an infinite amount of servo information can be employed within the virtual disk drive because it is generated on the fly. That is to say, because the servo information is generated in real time (i.e., on the fly), no buffering is required to deal with the servo information, and any desired amount of servo information can be employed. In some embodiments, as the disk is read within the virtual disk drive, information corresponding to each sector is gathered, and the servo information is generated there from on the fly using an FPGA within the virtual disk drive.

Generally speaking, a HDD includes a Head Disk Assembly (HDA) with magnetic media (one or multiple platters), an arm with magnetic head for read and write, a preamp, a motor for the arm (also called a voice coil motor), a spindle motor (to spin the media), and a printed circuit board with a read channel functional block (or integrated circuit), a controller functional block (or integrated circuit), and a motor control functional block (or integrated circuit). Newer devices combine the read channel and controller into a single System-on-a-chip (SoC) IC. To develop an HDD system, most of these components need to be functioning to a certain degree. One of the key systems is the Servo loop control system which keeps the head and media in sync to allow seeking of a track and read / write of a track by track-following. If any one of these components is not functioning, the head can crash and damage the disk. As a consequence, developers in industry typically base new HDD systems on previous HDD systems. Even then, the newer designed HDDs are often damaged during development.

Typically a read channel device can be tested with an Arbitrary Waveform Generator (AWG) and some of the controller software can be tested with a simulated HDA, or digital HDA.

A virtual disk drive, as implemented in accordance with the aspects presented herein, provides a complete virtual disk drive (sometimes referred to as a "Vdrive") to allow early development of any of the components even though the whole system or none of it may be functioning. The virtual disk drive provides for the development of the HDD system many months prior to arrival of silicon and many months prior to arrival of an HDA.

The virtual disk drive provides for a full host to media virtual system allowing a user interface (e.g., a PC) to talk to the virtual disk drive over an HDD interface bus (like CE-ATA or CF+). This allows development of host software. In addition, the virtual disk drive provides a simulation environment that ties directly to the IC development environment. The virtual disk drive provides for significantly larger amounts of real-time or non-real-time data than an AWG, as typically used in the prior art, can provide. This allows development of software that requires multiple tracks of data. The difference between our implementation and an AWG implementation is indicated by the term "large scale" in the following items.

The virtual disk drive provides for:
1. large scale servo implementation
2. large scale servo implementation including microjogs
3. large scale spindle implementation
4. large scale spindle implementation with clock variance
5. large scale actuator implementation
6. large scale actuator implementation w/ resonances
7. large scale implementation with Analog output with pulse shapes
8. large scale implementation with Analog output with pulse shapes that can be a percentage mix of two different pulses
9. large scale implementation with Analog output with Inter-Symbol-Interference (ISI), noise, & distortion
10. large scale implementation of ECC and reverse ECC

The virtual disk drive also provides for separate control software that can preload or read tracks of information. Generally speaking, the virtual disk drive provides for a very compact solution that does not require any test equipment as is required using prior art approaches.

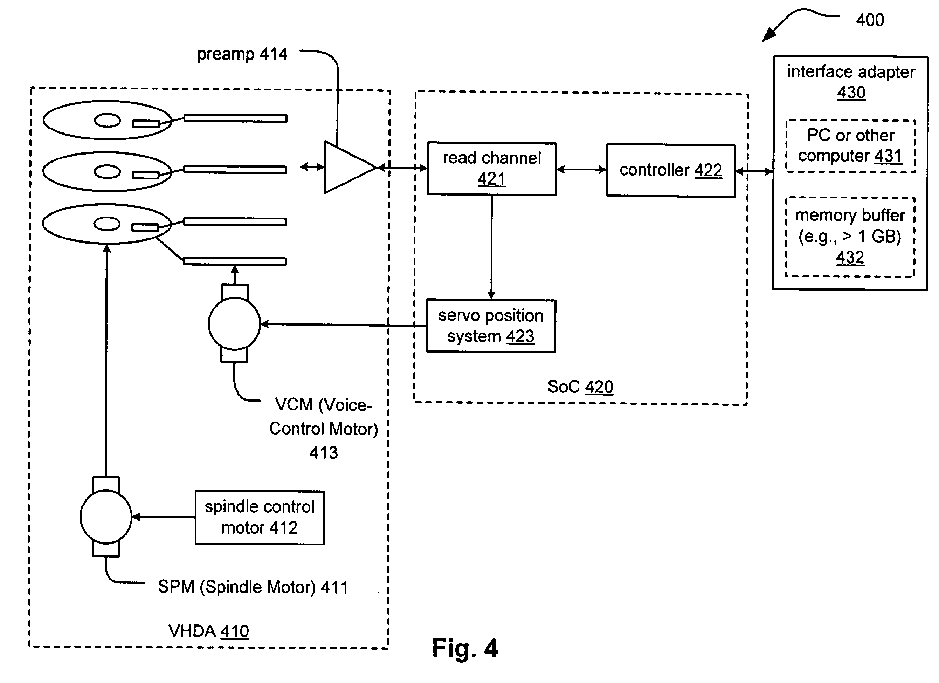

FIG. 4 illustrates an embodiment of a system 400 including hard disk drive (HDD). This system 400, as well as other embodiments depicted herein, can be viewed as showing the elemental components used within an HDD design system. Various components within the HDD include the actual disk (which may include multiple magnetic recording layers (i.e., platters) mounted on the spindle. A SPM (Spindle Motor) 411 is governed by a spindle control motor 412 to direct the rotation of the platters. A VCM (Voice-Control Motor) 413, as directed by the servo position system 423, operates to position the read/write head assembly over various positions of the media. Based on the actual location on the media over which the arm is situated, information is written to or read from the media and passed through a read channel functional block or module 421, which also directs the servo position system 423 to move the head assembly accordingly. A VHDA (Virtual Hard Disk Assembly) 410 includes the VCM 413, the SPM 411, a preamp 414, the media, etc.

A controller functional block or module 422 is also coupled to the read channel functional block or module 421 which couples to the preamp 414, and the controller functional block or module 422 also couples to an interface adapter 430. The interface adapter can be that of a computer (e.g., a personal computer or other type of computer, as shown by reference numeral 431) which allows a designer to control and direct various components of virtual disk drive during testing. The interface adapter can also include a memory buffer 432 that is operable to store simulation data corresponding to any of the various components within the system 400, which can be viewed as being a HDD design system. This memory buffer 432 can be extremely large in some instances, including sizes up to and larger than 1 GB thereby allowing significantly more simulation data to be stored than is available in any prior art approach. In some embodiments, the read channel functional block or module 421, the controller functional block or module 422, and the servo position system 423 are all incorporated within a single integrated circuit such as can be implemented using a SoC (System on a Chip) 420. One or more of the various elements presented in this embodiment can be integrated as well without departing from the scope and spirit of the invention.

In this embodiment, the VHDA 410 is operable to simulate operation of at least one of a storage media, a spindle motor, and an arm within an HDD system. The read channel module 421 is operable to simulate operation of a read channel within the HDD system, and the controller module 422 that is operable to simulate operation of a controller within the HDD system. The servo position module 423 is operable to simulate operation of a servo position system within the HDD system, and a user interface (e.g., such as depicted using the interface adapter 430) is operable to permit modification of at least one operating parameter within the HDD design system. The servo position module 423 is operable to generate servo position data in the fly in real time, so there is no limiting by the memory buffer of the amount of servo position data that can be employed within the HDD design system.

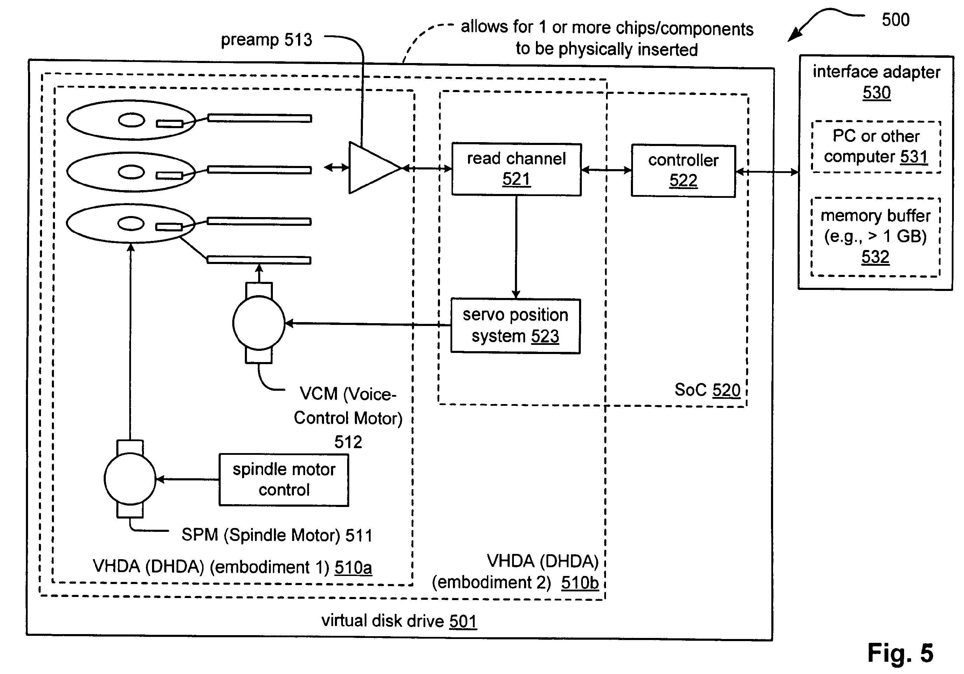

FIG. 5 illustrates an embodiment of an HDD design system 500. The entirety of an actual HDD system can be modeled using a virtual disk drive and other components within the HDD design system 500. This system 500 of FIG. 5 is analogous to that of the previous diagram, and each of the components of the HDD design system 500 is emulated/simulated within a virtual disk drive 501. The VHDA can be implemented as a DHDA (Digital Hard Disk Assembly), if desired, that can include digital circuitry including FPGAs or other components. For example, any one or more of the VHDA, the read channel module 521, the controller module 522, and the servo position system or module 523 can be implemented using one or more FPGAs.

One of two possible embodiments of the VHDA (DHDA) can be implemented (as shown by reference numerals 510a and 510b). If desired, the read channel functional block or module 521 and the servo position system 523 can be included within the VHDA (DHDA) 510b (embodiment 2) or outside of the VHDA (DHDA) 510a (embodiment 1).

It is again noted that the virtual disk drive allows for the emplacement of 1 or more chips (i.e., integrated circuits) and/or components to be physically inserted therein. For example, any one of the channel module 521 or the controller module 522 can be implemented, in whole or in part, using an integrated circuit. This allows for certain of the components within the HDD design system 500 to be actual, and other of the components within the HDD design system 500 to be virtual. This allows for a broad range of testing capabilities, in that, any component combination of virtual and actual (including all virtual) can be employed within the HDD design system 500. This allows for a much better testing approach than is available within prior art approaches.

By providing the ability to emulate/simulate each of the components within an HDD system using the virtual disk drive 501 and components thereof, developers and designers are provided with much more accurate and complete analytical information to be used in developing an overall HDD system.

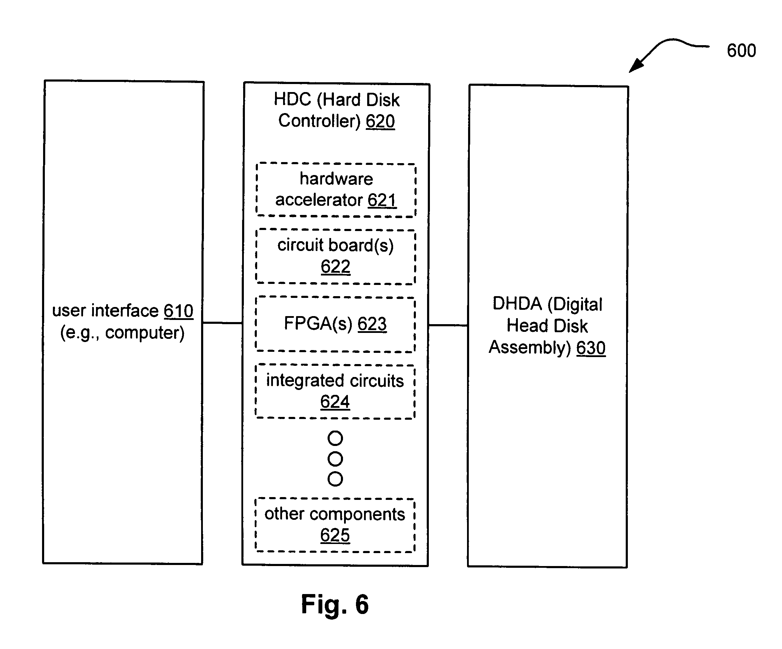

FIG. 6 illustrates an embodiment of an HDD system 600 that includes a virtual disk drive. The HDD design system 600 includes a user interface 610 (e.g. a computer such as a PC (Personal Computer) or otherwise), an HDC (Hard Disk Controller) 620 (e.g., a controller functional block), and a DHDA (Digital Hard Disk Assembly) 630. The HDC 620 can be implemented using a hardware accelerator 621, 1 or more circuit boards 622, 1 or more FPGAs 623, 1 or more integrated circuits 624, and/or 1 or more other components. The user interface 610 allows for the manipulation and providing of various signals provided to and from each of the various components within the HDD design system 600, as well as monitoring the performance thereof.

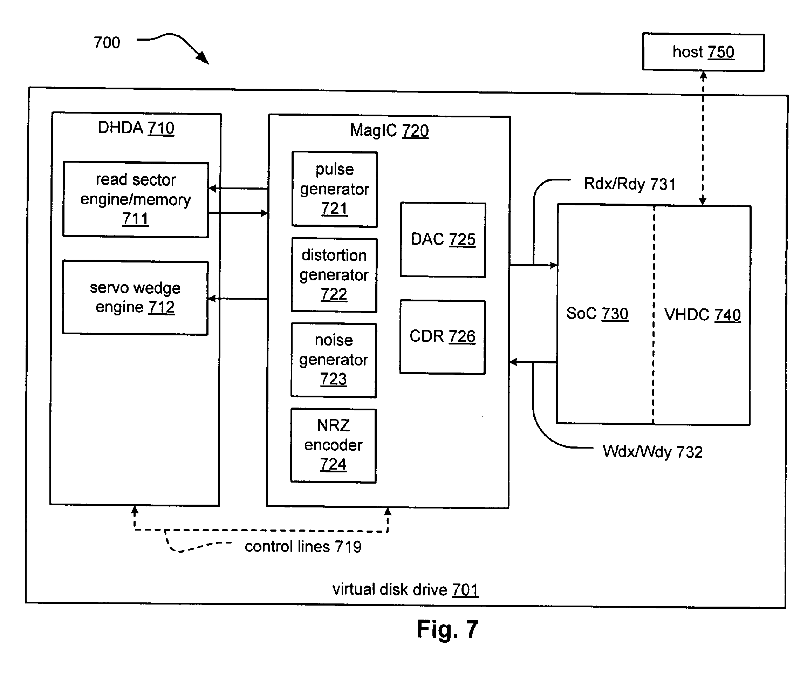

FIG. 7 illustrates an alternative embodiment of an HDD design system 700. The HDD design system 700 includes a virtual disk drive 701 that includes a DHDA 710 that includes a read sector engine/memory 711 and a servo wedge engine 712. As also described above in other embodiments, the servo related information (e.g., simulation data) of the virtual disk drive 701 is generated in real time which allows an unlimited of such information to be employed. A MagIC functional block or module (magnetic inverse channel functional block or module) 720 allows for the emplacement of actual integrated circuits and/or components within the HDD design system. For example, an actual integrated circuit can be implemented in the MagIC functional block or module 720 to allow more complete and accurate testing and analysis thereof. Control Lines 719 can be provided between the DHDA 710 and the MagIC functional block or module 720, if desired, to allow communication and control there between. The MagIC functional block or module 720 is operable to perform a variety of functions by using a pulse generator 721, a distortion generator 722, a noise generator 723, a NRZ (Non-Return to Zero) encoder 724, a CDR functional block 726, and a DAC (Digital to Analog Converter) 725.

Read and Write operations (as depicted by Rdx/Rdy 731 and Wdx/Wdy 732, respectively) are performed between an SoC/VHDC, reference numerals 730 and 740, respectively, and the MagIC functional block or module 720. A host 750 is also implemented which communicates with the VHDC 740. The host 750 can be an interface adapter, an interface adapter which can be a computer (e.g., a personal computer or other type of computer) which allows a designer to control and direct various components of virtual disk drive during testing within the HDD design system, 700. The host 750 can also include a memory buffer 432 is operable to store simulation data corresponding to any of the various components within the HDD design system 700.

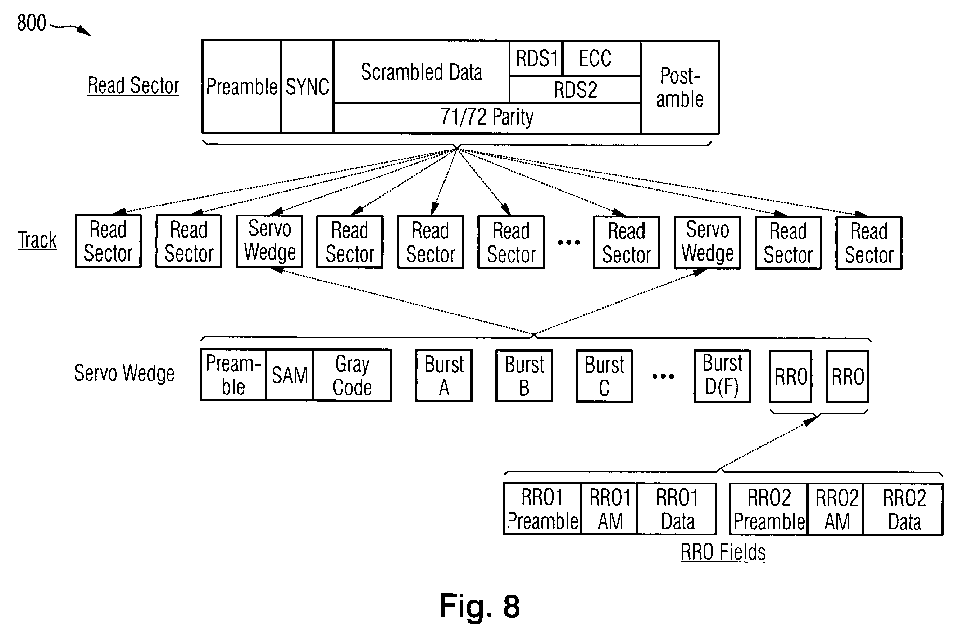

FIG. 8 illustrates an embodiment of read and servo event signals 800. Perhaps one of the most important elements in performing accurate and complete testing and diagnostics of within a virtual disk drive environment is the digital signals that are employed therein. Stated another way, if the digital signals that are employed within the virtual disk drive are not accurate, then the modeling, simulations, testing, etc. will not be accurate. Some background of the format of the tracks of the storage media are provided below.

Each track includes read sectors with servo wedges interspersed therein. Each read sector has the format as shown at the top of the diagram. Each servo wedge then includes the format as indicated below that, and each servo wedge is terminated with RRO (Repeatable Runout) fields.

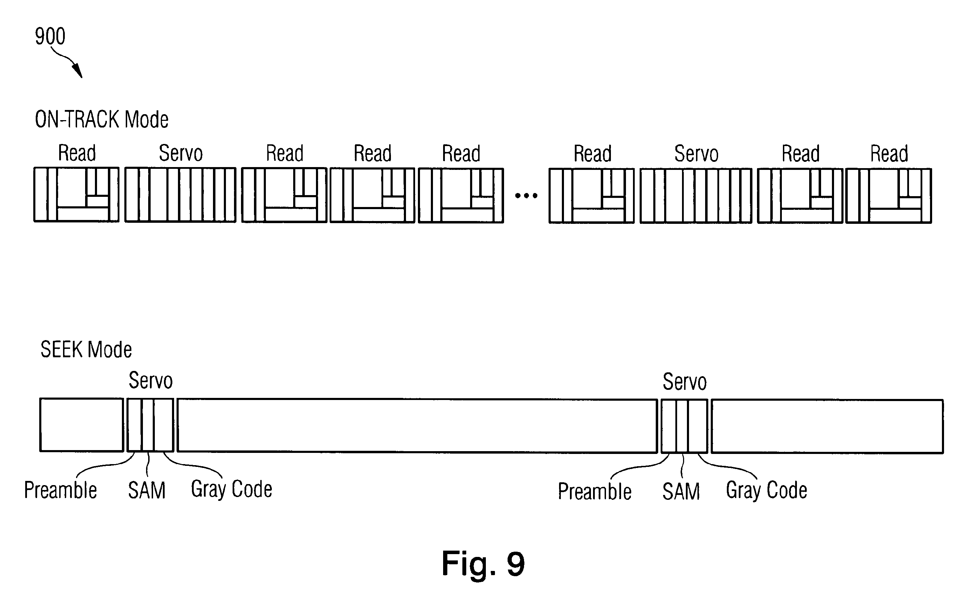

FIG. 9 illustrates an embodiment of signals employed when operating in on-track and seek modes, respectively. When operating in the on-track mode, a read sector may be followed by a servo wedge, which is then followed by a plurality of read sectors, and so on. When operating in the seek mode, the servo wedges are particularly employed to find the desired location. Each servo wedge includes the fields of a preamble, a SAM (Servo Address Mark), and a Gray code.

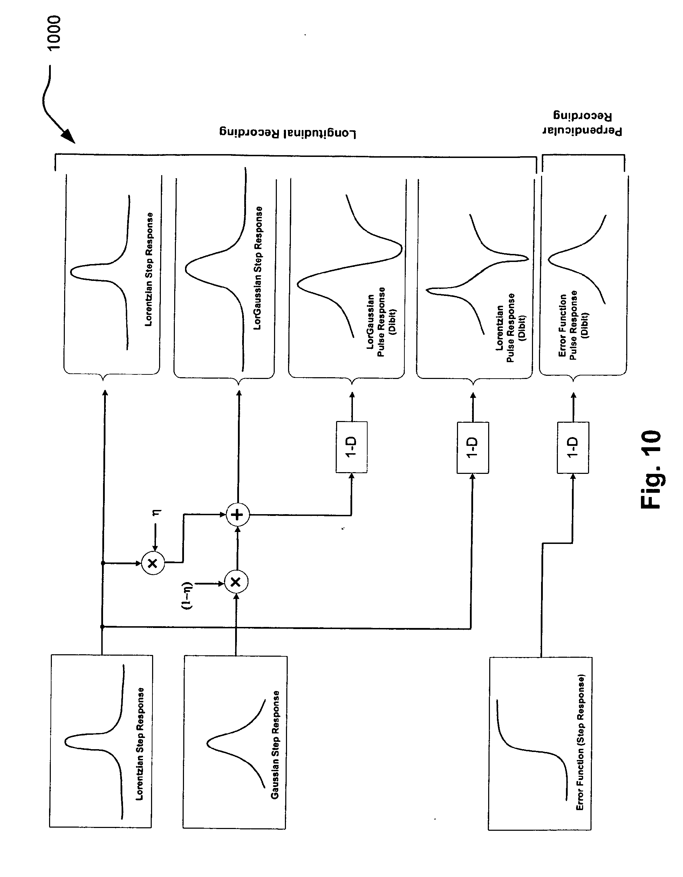

FIG. 10 illustrates an embodiment of various convolutional signals that are generated by magnetic pulses. As mentioned above, accurate generation of signals that actually exist within an HDD system, including the imperfections, distortion, and noise therein, is paramount to ensuring accurate modeling of the HDD system. Various means to generate the signals employed within the magnetic channel and any convolution performed on the signals therein are described below.

At least 3 signals are employed including a Lorentzian step response, a Gaussian step response, and an error function (step response). For proper modeling in either of the PMR (Perpendicular Magnetic Recording) or LMR (Longitudinal Magnetic Recording) environments, appropriate generation of the signals included within these types of systems is needed. Any of these 3 input signals can be employed directly (e.g., the Lorentzian step response can be employed directly within an HDD system using LMR). However, oftentimes a combination of these signals, after undergoing any appropriate convolution, provides for even better and more accurate signal modeling.

For example, a LorGaussian step response is a combination of the Lorentzian step response and the Gaussian step response, after each has undergone some appropriate scaling. In addition, a LorGaussian pulse response (Dibit) can be achieved as providing a more accurate channel estimate of the HDD system. Similarly, a Lorentzian pulse response (Dibit) can also be achieved within an HDD system employing LMR.

Within an HDD system employing PMR, an error function pulse response (Dibit) can be employed.

Any one of these various responses (Dibits) can be employed within a virtual disk drive to perform a more complete and accurate testing and simulation of an HDD system than is currently available within prior art systems.

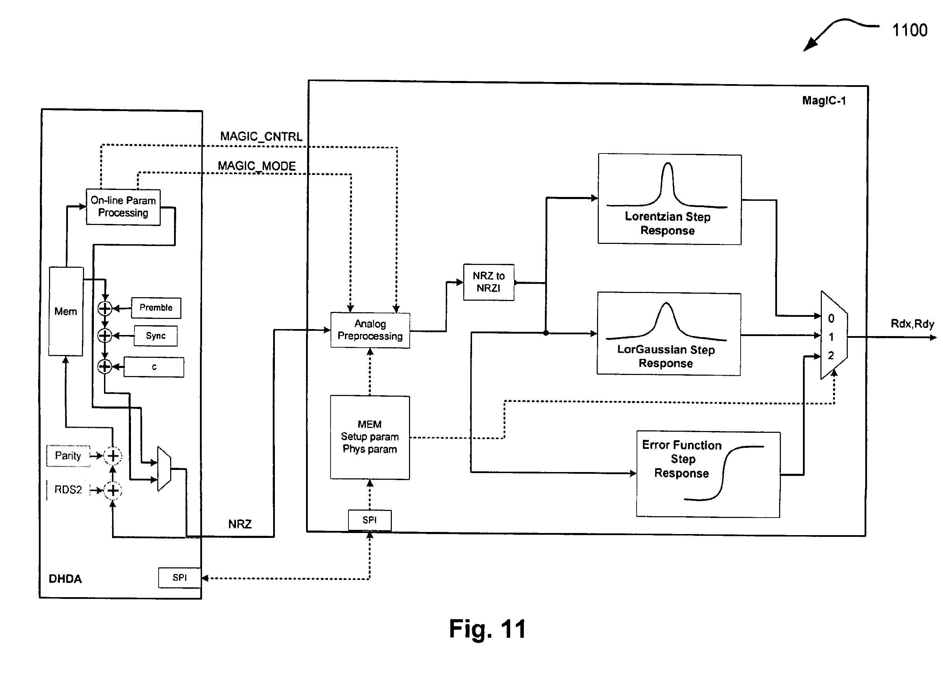

FIG. 11 illustrates an embodiment of a step response based architecture 1100.

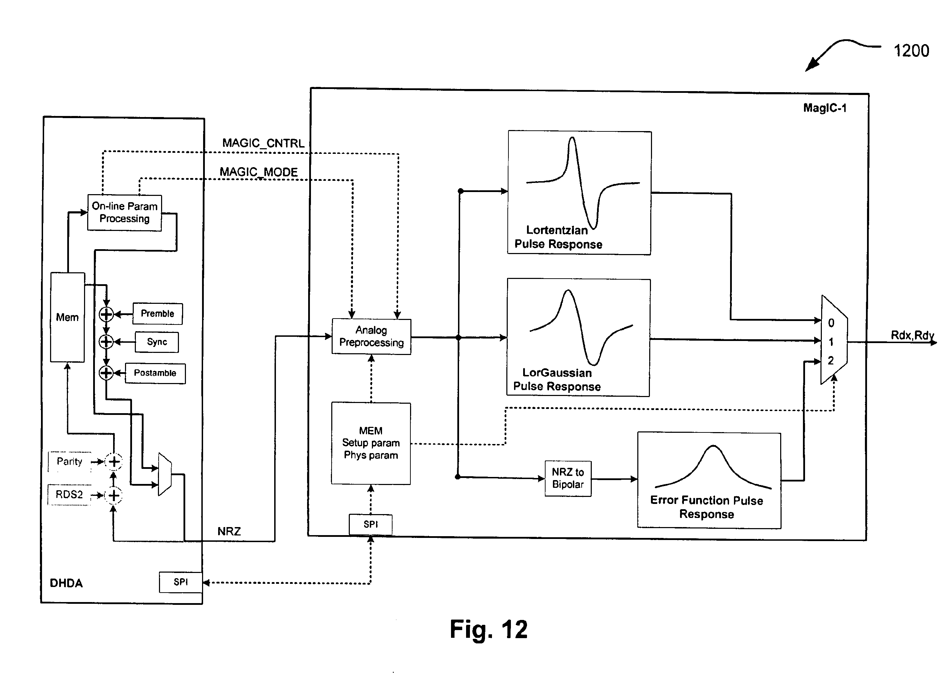

FIG. 12 illustrates an embodiment of a pulse response based architecture 1200.

As can be seen when comparing each of the FIG. 11 and FIG. 12, 6 different signals can be selected as desired within a particular embodiment including the step responses, or the pulse responses within a virtual disk drive.

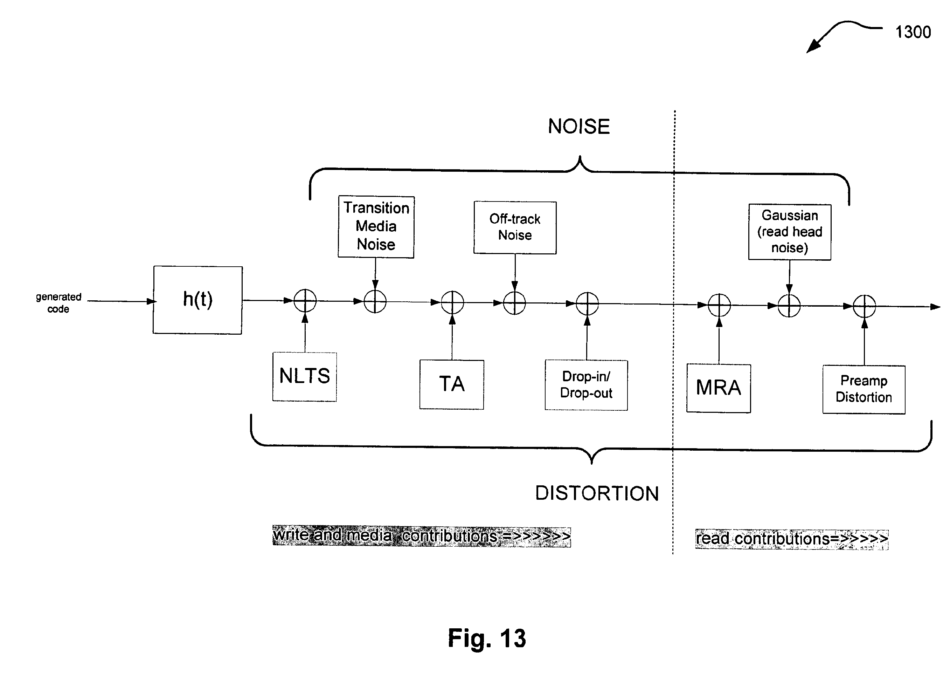

FIG. 13 illustrates an embodiment of a noise and distortion basic model 1300. A generated code signal is provided to the channel model (h(t)), and various components of noise and distortion are then added thereto. These components can be partitioned into those contributed by both of the write and the read operations as well as those only generated by the read operations.

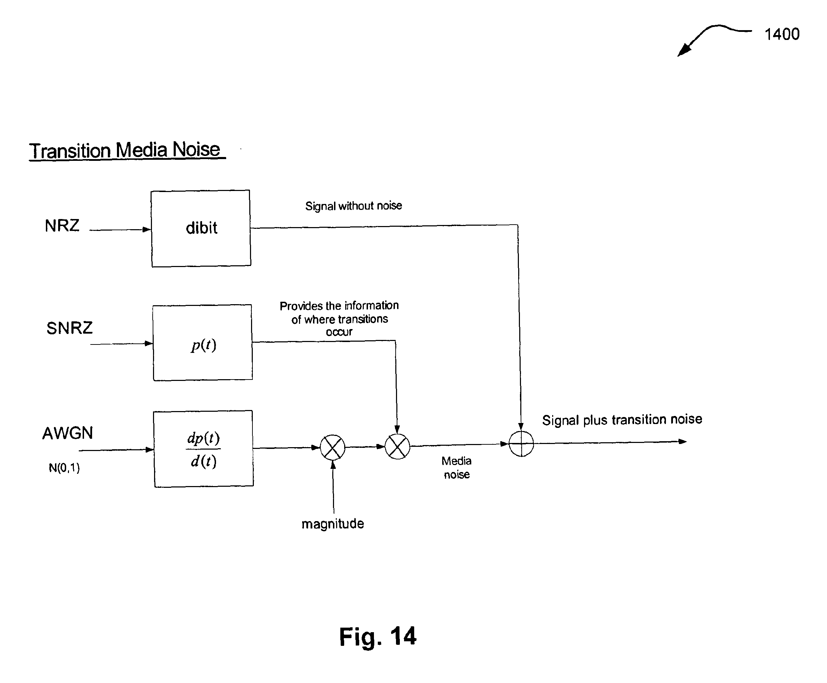

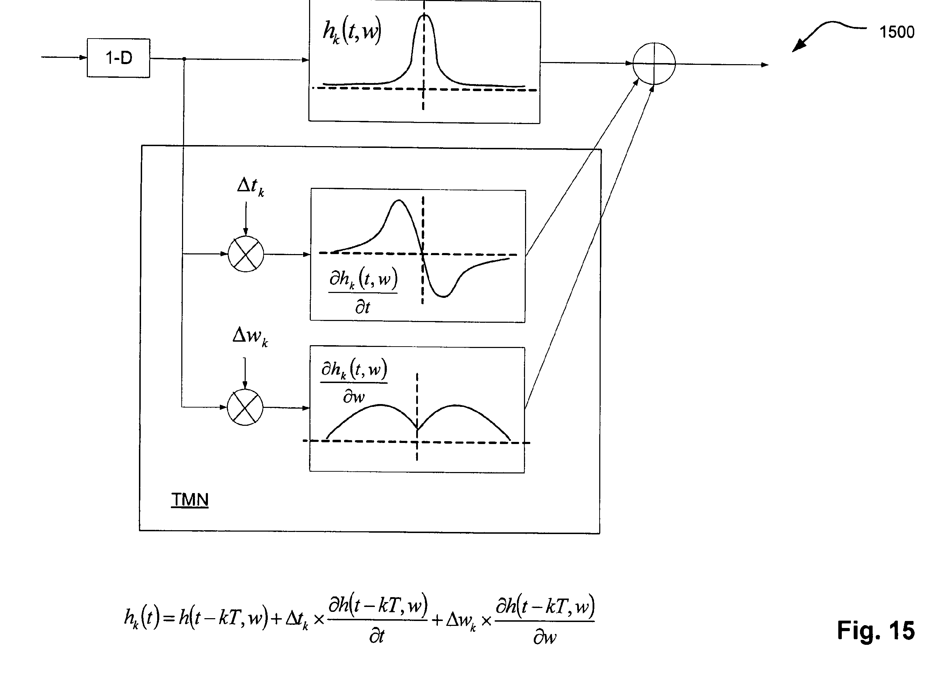

FIG. 14 illustrates an embodiment of a first model of transition media noise 1400, and FIG. 15 illustrates an embodiment of a second model of transition media noise 1500. A signal that includes transition noise is the output of each of these models.

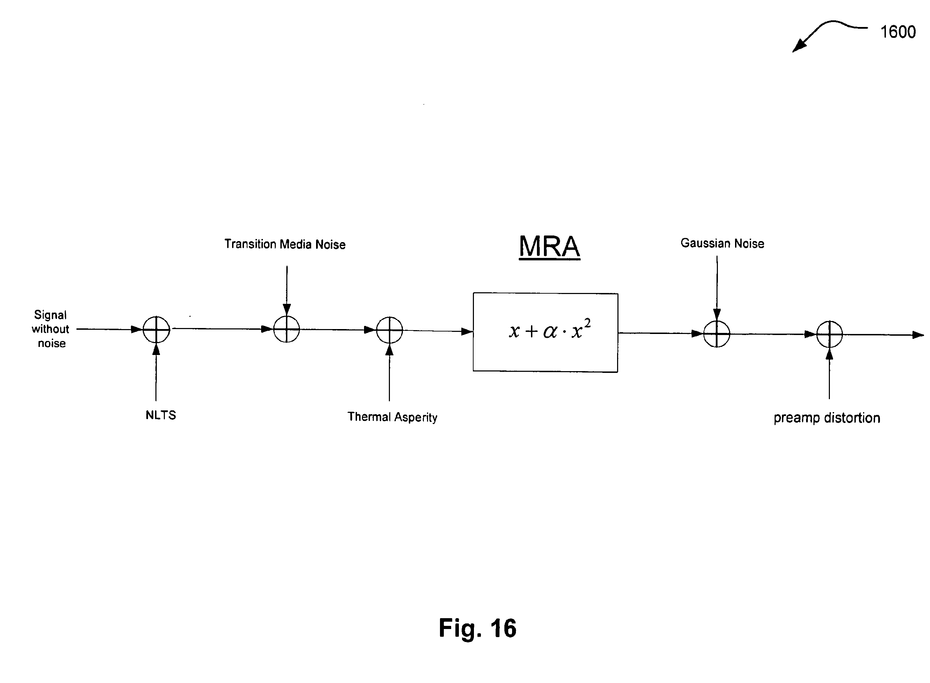

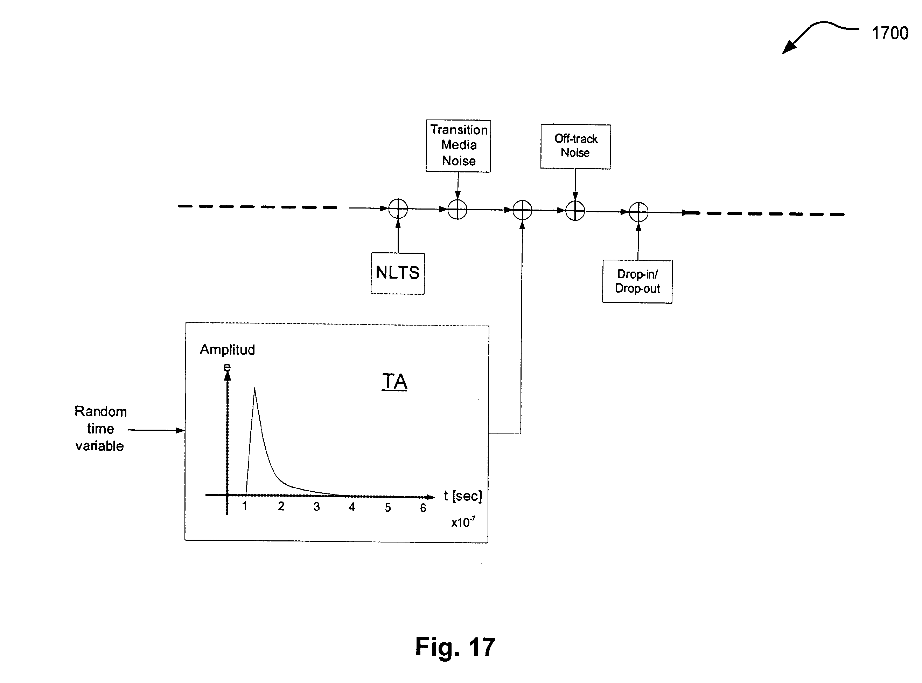

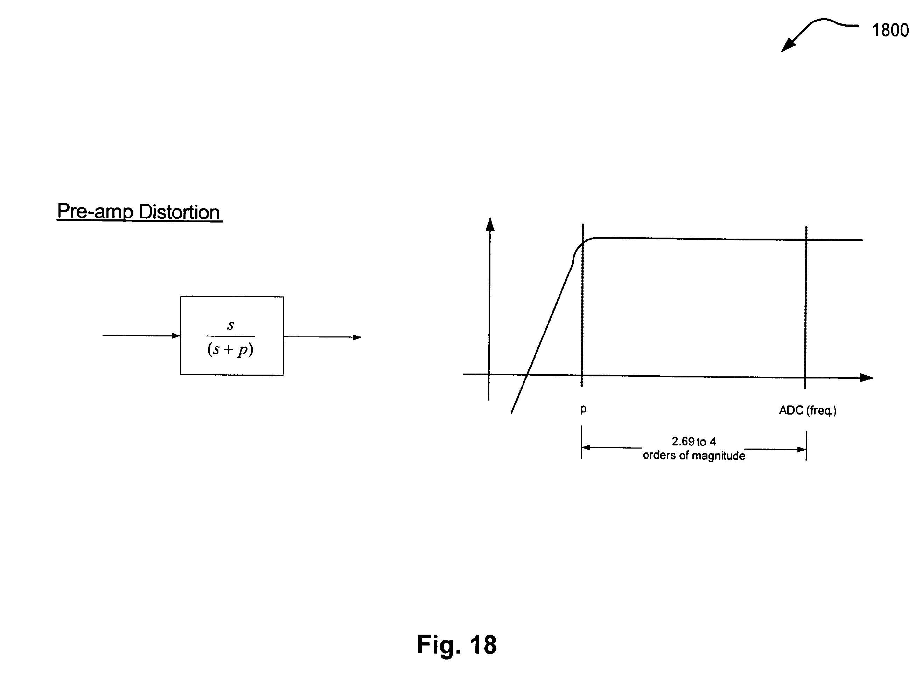

FIG. 16 illustrates an embodiment of MRA (Magneto-Resistive Asymmetry) 1600, FIG. 17 illustrates an embodiment of thermal asperity 1700, and FIG. 18 illustrates an embodiment of preamp distortion 1800.

Each of these various models as described above can be employed for accurate simulation and modeling of the various components, and the effects experienced by them, during operation of the HDD system that is being modeled using a virtual disk drive.

As mentioned above, a critical component to performing accurate testing using a virtual disk drive is the accurate generation of the signals employed and typically seen within a HDD system. Various convolution architectures are presented below including a digital FIR (Finite Impulse Response) architecture, an analog FIR architecture, and a resistor network.

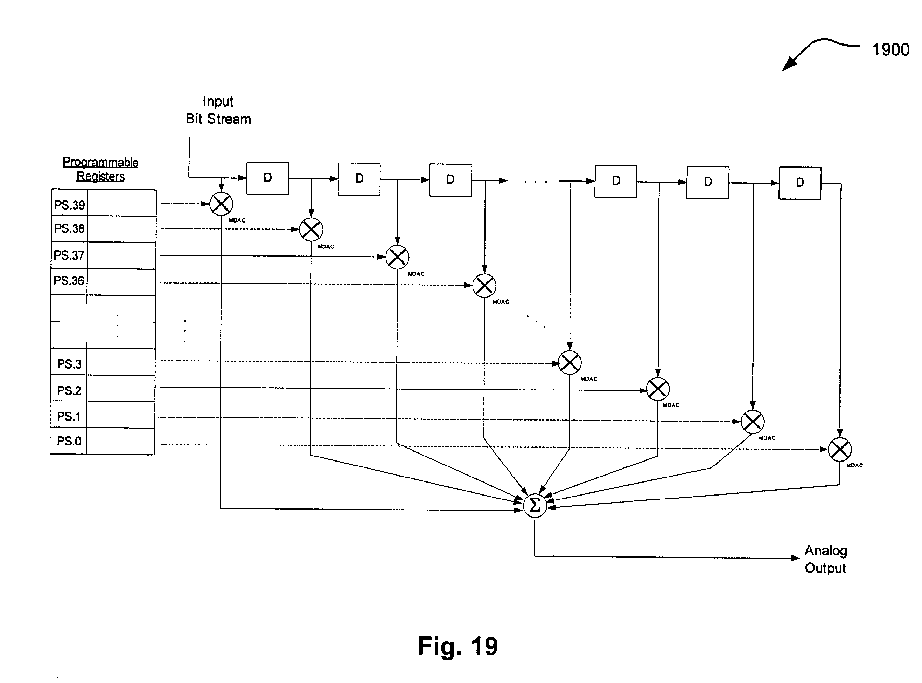

FIG. 19 illustrates an embodiment of a DAC/FIR (Digital to Analog Converter/Finite Impulse Response Filter) architecture. An input bit stream is provided to a number of delays. The actual input bit stream, as well as each output from the cascaded delays, is provided to a corresponding multiplier. The value of each of the multipliers is programmable as depicted using a number of programmable registers. The ultimate output is an analog output signal.

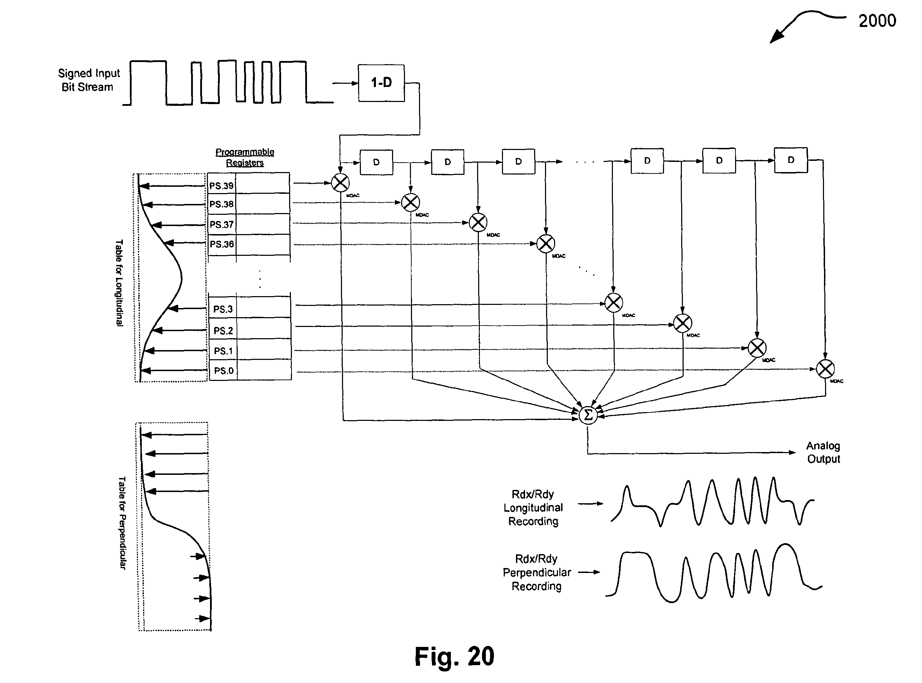

FIG. 20 illustrates an embodiment of a FIR step response architecture 2000.

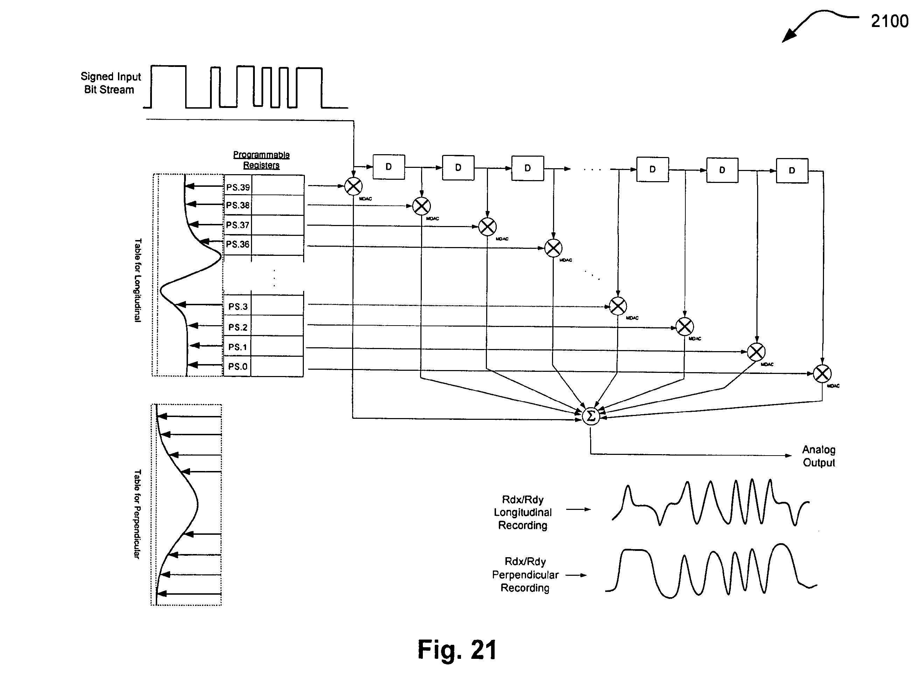

FIG. 21 illustrates an embodiment of a FIR pulse response architecture 2100.

Each of these FIG. 20 and FIG. 21 is a variation of the embodiment of FIG. 19. The values of the programmable registers can be viewed as being a table that is employed to generate the signals employed within the virtual disk drive. Depending on whether LMR (Longitudinal Magnetic Recording) or PMR (Perpendicular Magnetic Recording) is desired, the appropriate values within the programmable registers can be modified accordingly.

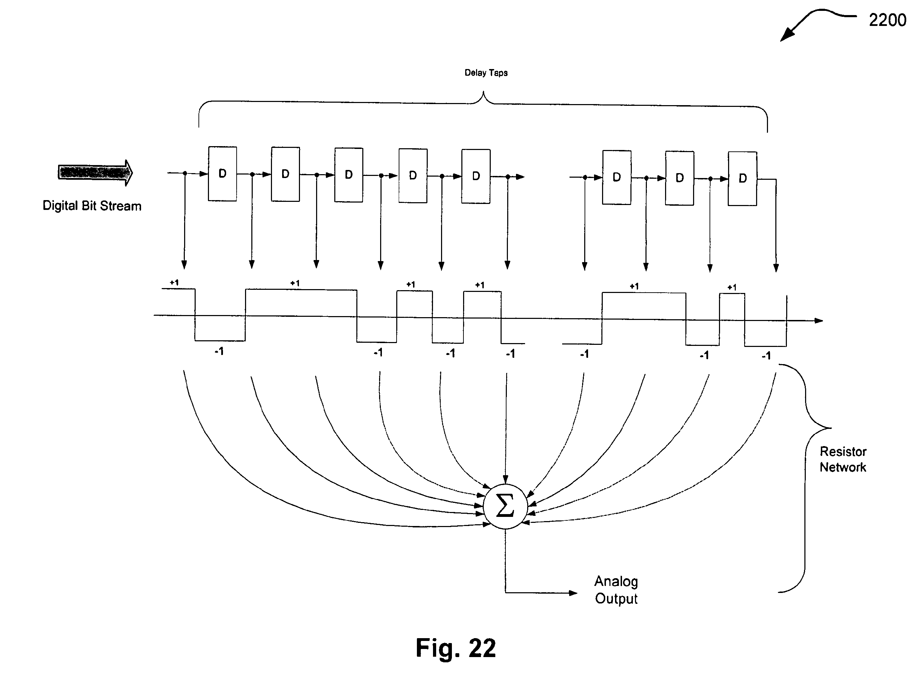

FIG. 22 illustrates an embodiment of a resistor network architecture 2200. An analogous delay line including a plurality of delay taps can be employed, but a resistor network is instead employed to generated the signals that are all summed together thereby generating the analog output signal.

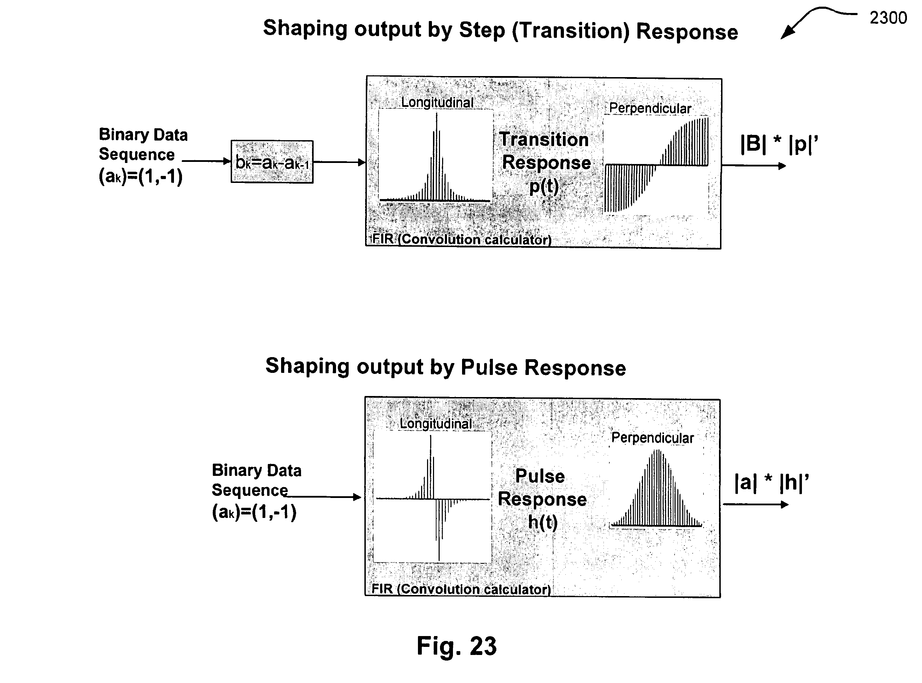

FIG. 23 illustrates an embodiment 2300 of approaches to shaping an output by either a step (transition) response or a pulse response. Each of these is shown as being able to accommodate either LMR or PMR, whichever is desired. A binary sequence is provided to an FIR (convolution calculator) to generate the convolved signal as corresponding to the appropriate type of HDD system (e.g., either PMR or LMR).

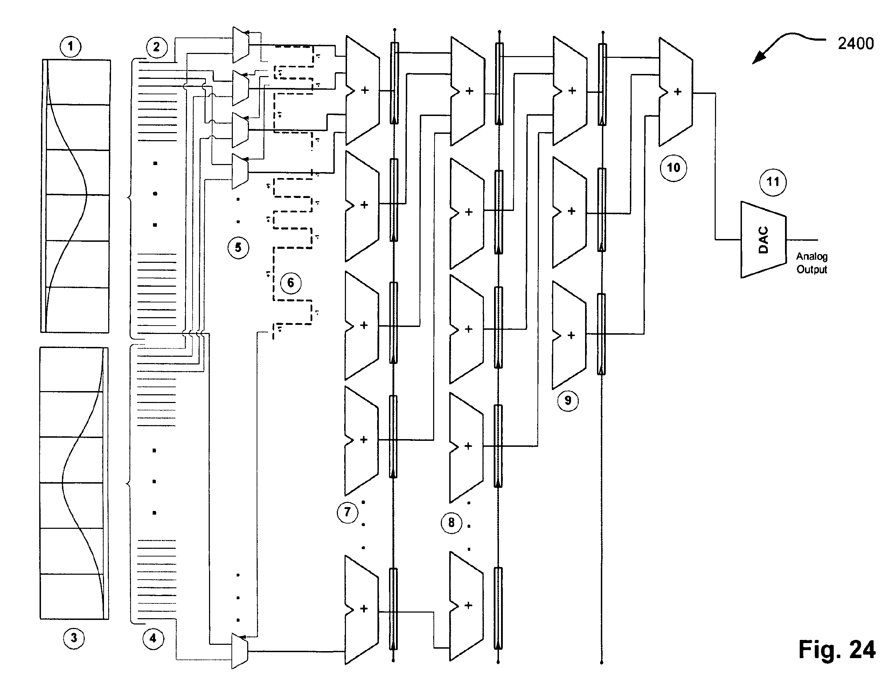

FIG. 24 illustrates an embodiment 2400 of a FIR implementation in conjunction with a DAC. A number of MUXs (Multiplexors) can be employed, the final output of which is provided to a DAC (Digital to Analog Converter) thereby generating the output analog signal.

Various details about the MagIC functional block and capability, as referenced above, are also provided below. In certain embodiments, the MagIC capabilities provide for a frequency range of 50 Mbps to 600 Mbps, a voltage dynamic range from 100 mV to 1 V, and an input sequence of an NRZ signal having 12 bit parallel symbols. Either PMR or LMR recording types can be accommodated. The transition time of the elements can be adjusted (e.g., from 10 nsec to 20 nsec) to control the amount of ISI (Inter-Symbol Interference) induced. Also, the MagIC capabilities can be adapted to provide for media noise and thermal asperity.

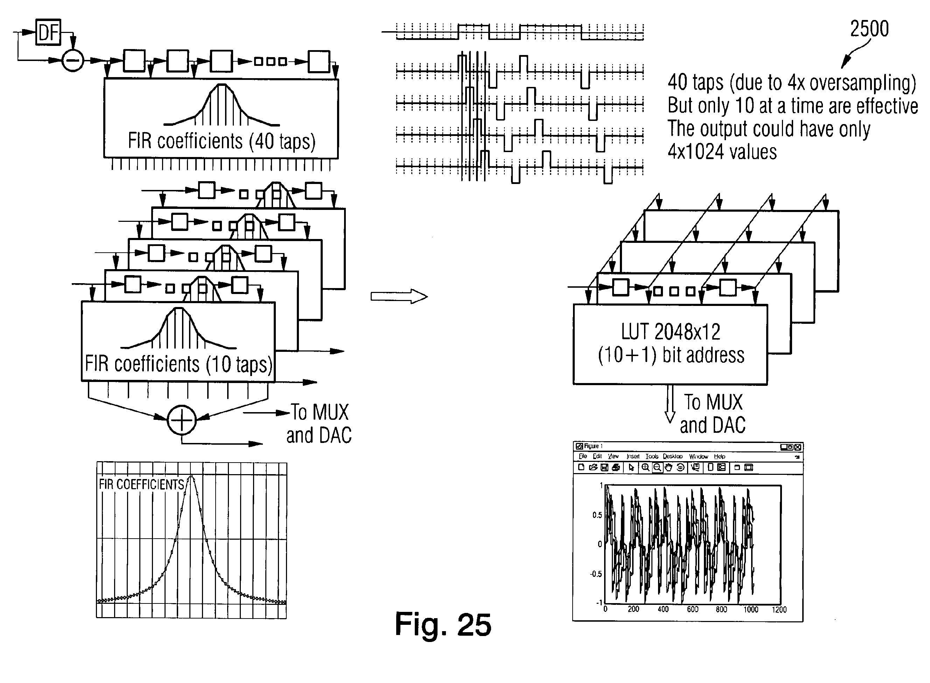

FIG. 25 illustrates an embodiment 2500 of LUT (Look Up Table) based implementation adapted for HDD systems employing LMR (Longitudinal Magnetic Recording). An FIR with 40 taps (due to 4x oversampling) can be employed, but only 10 taps are effective at any time. The output could have only 4 × 1024 values, if desired.

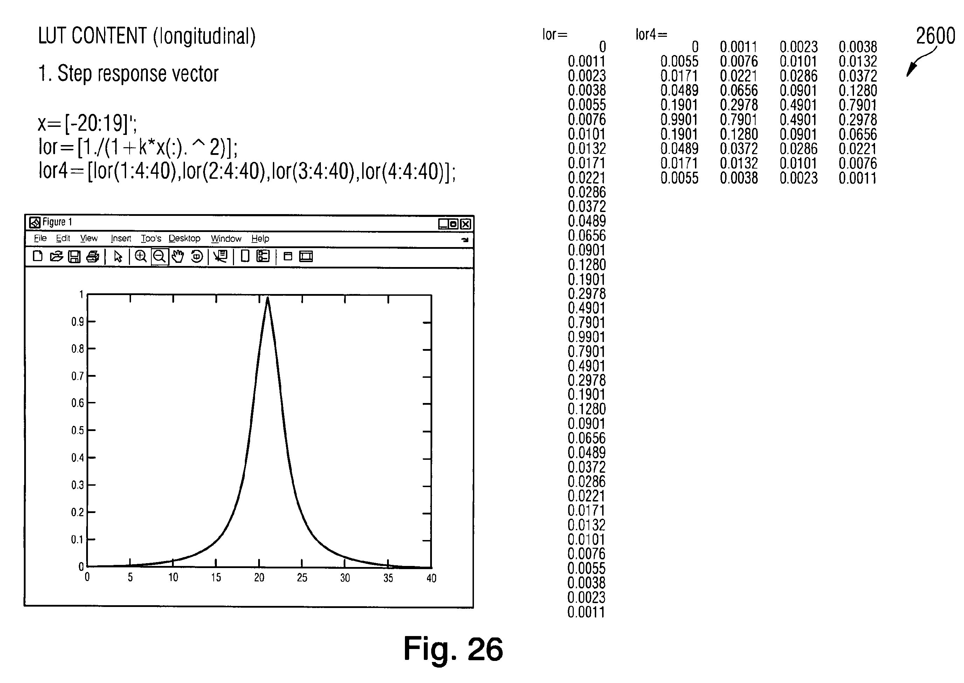

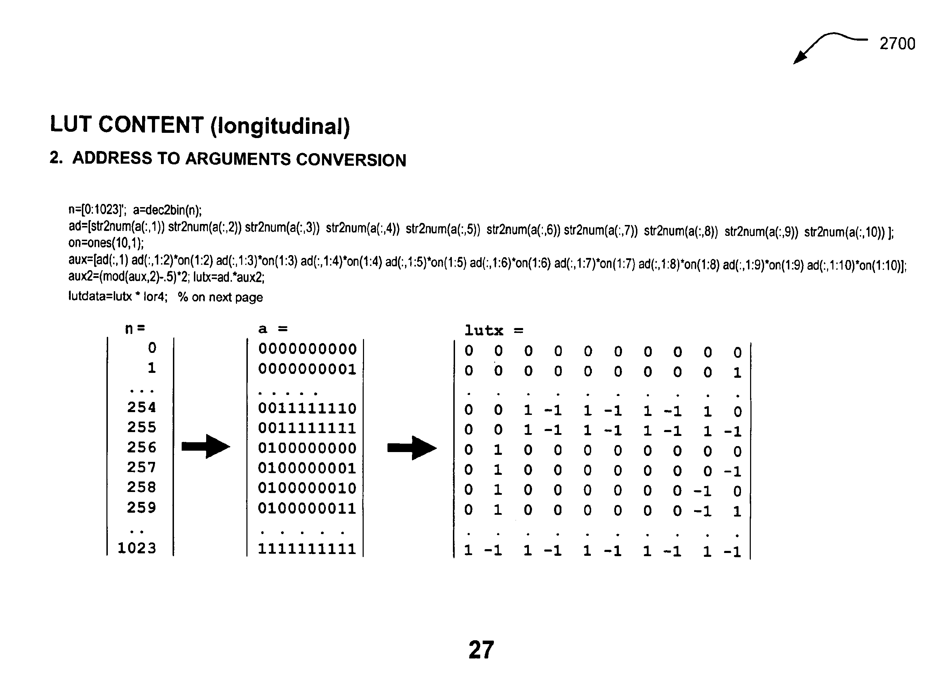

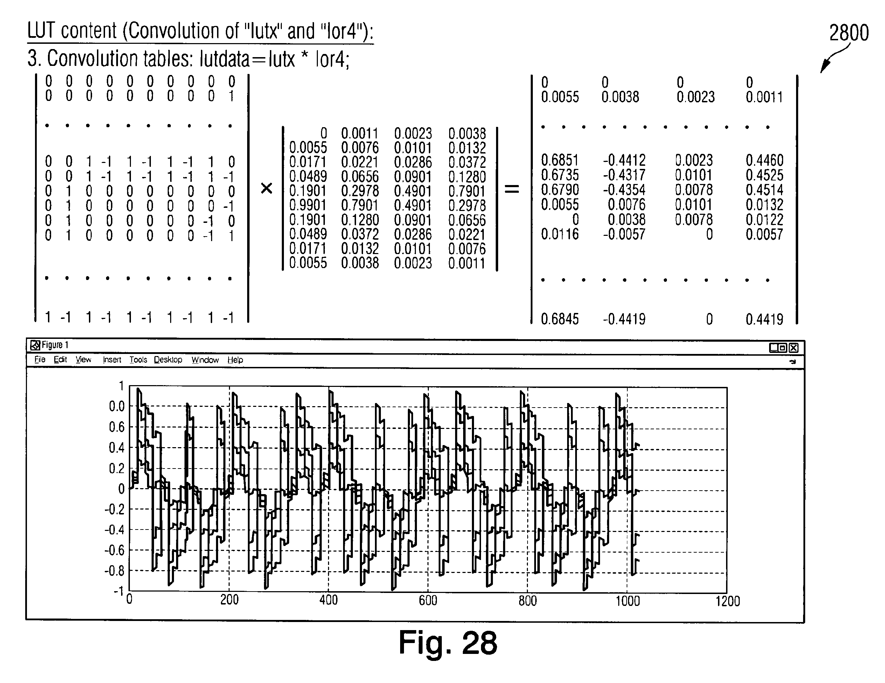

FIG. 26, FIG. 27, and FIG. 28 illustrate embodiments 2600, 2700, and 2800, respectively, of the LUT contents as adapted for LMR (e.g., such as illustrated within FIG. 25).

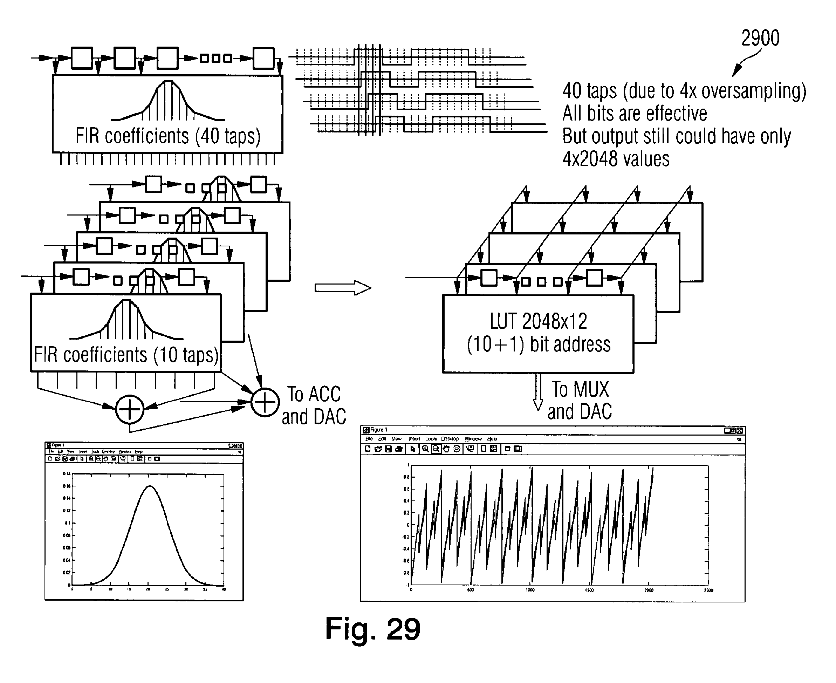

FIG. 29 illustrates an embodiment of LUT (Look Up Table) based implementation adapted for HDD systems employing PMR (Perpendicular Magnetic Recording). Again, an FIR with 40 taps (due to 4x oversampling) can be employed, but all bits can be effective in this embodiment. The output could have only 4 × 2048 values, if desired.

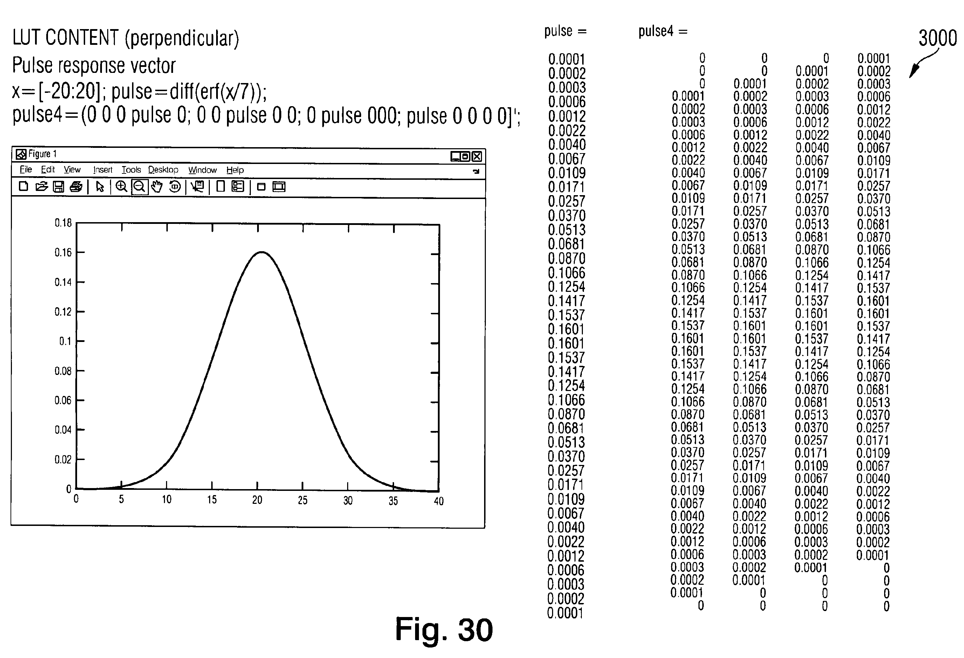

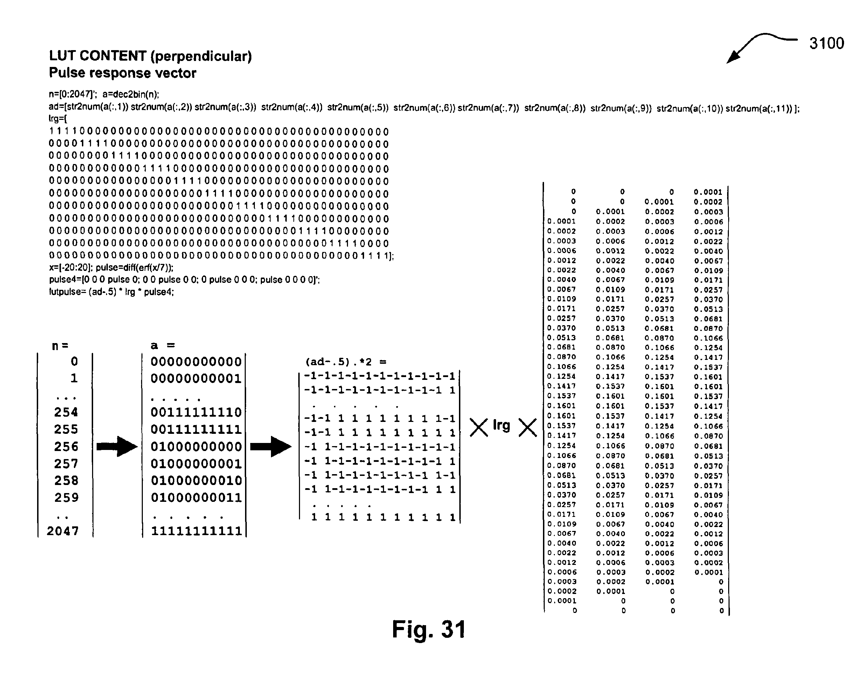

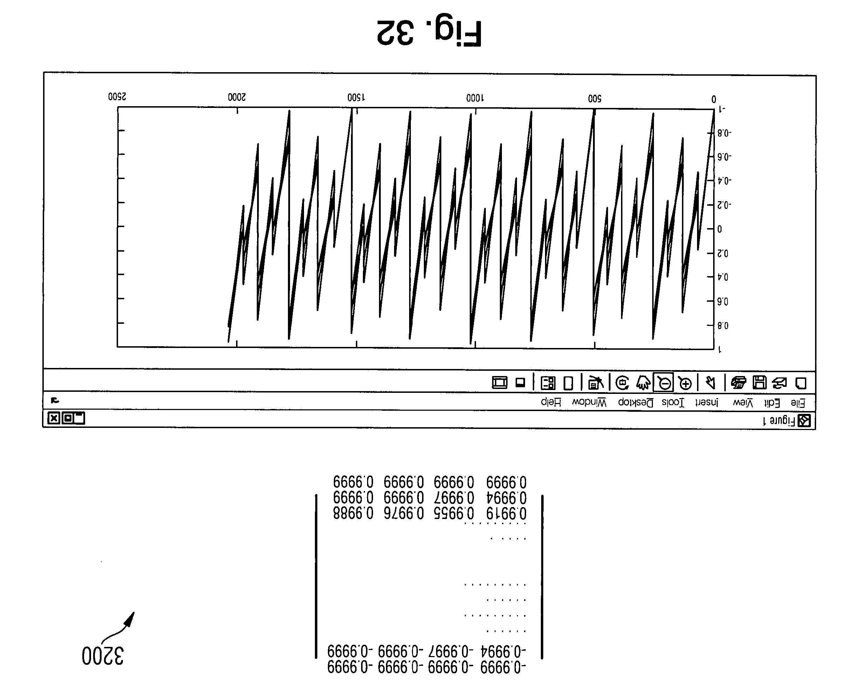

FIG. 30, FIG. 31, and FIG. 32 illustrate embodiments 3000, 3100, and 3200, respectively, of the LUT contents as adapted for PMR (e.g., such as illustrated within FIG. 29).

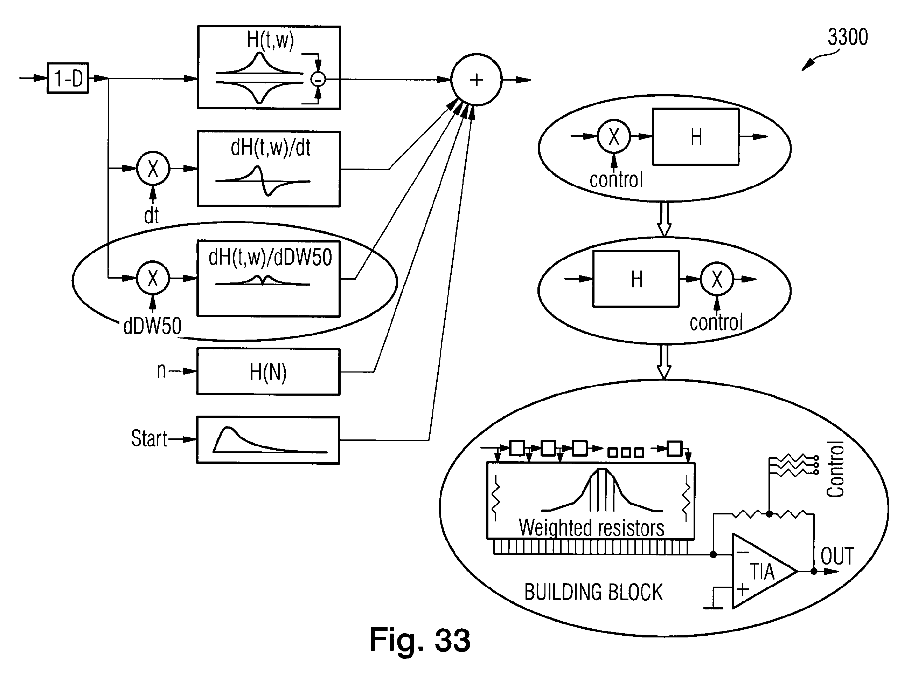

FIG. 33 illustrates an embodiment 3300 of a resistor network approach. As can be seen, the basic building block of this system is a delay line with multiple taps, a plurality of weighted resistors, and a TIA (Trans-Impedance Amplifier) from which the output signal is provided.

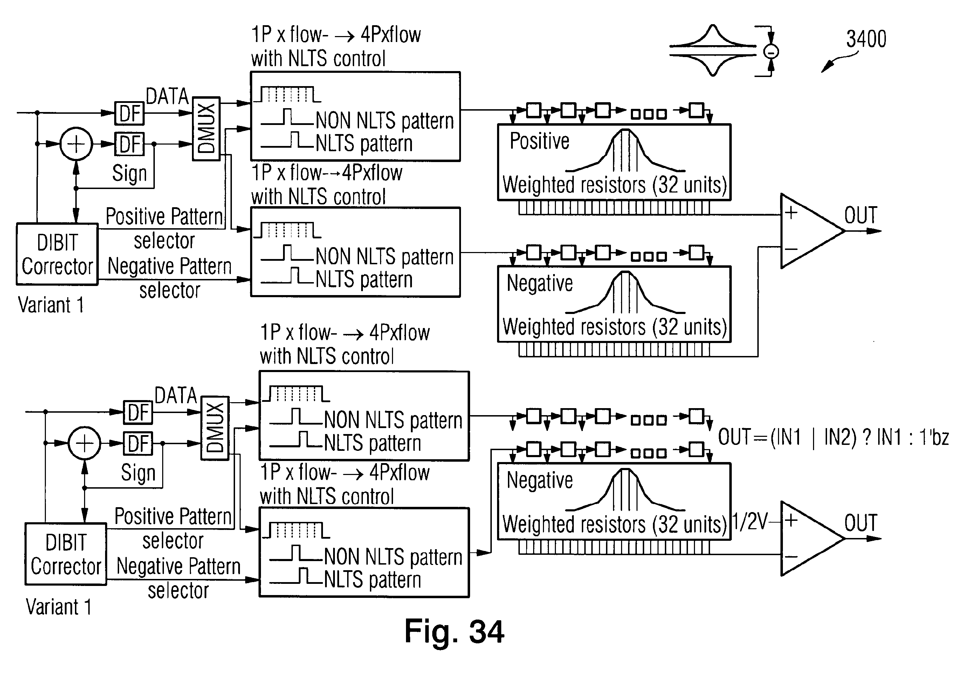

FIG. 34 illustrates embodiments 3400 (variant1 and variant2) of resistor network implementations. The variant 2 allows for the re-use of a singular plurality of weighted resistors when compared to the variant 1.

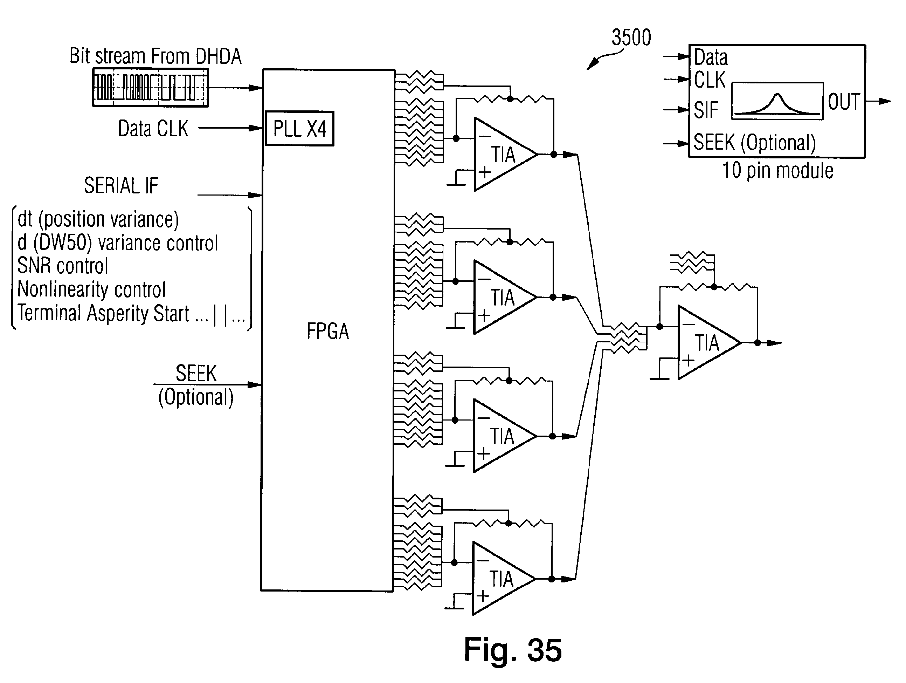

FIG. 35 illustrates an embodiment 3500 of a resistor network implementation in conjunction with a field programmable gate array (FPGA). An FPGA whose inputs are provided by a plurality of resistors, are each provided to a cascaded plurality of TIAs, the ultimate output of which is output from the last TIA.

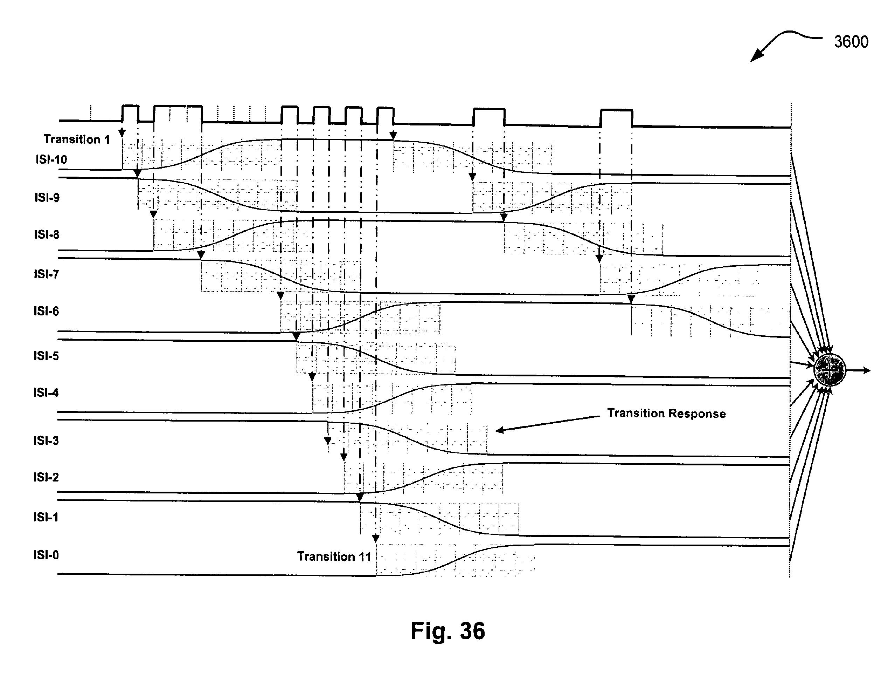

FIG. 36 illustrates an embodiment 3600 of analog convolution for HDD systems employing LMR. In this embodiment 3600, each transition (depicted in red) in the data stream launches a separate "analog transition response generator" with specific transition response (rise or fall time) and a variable pulse duration.

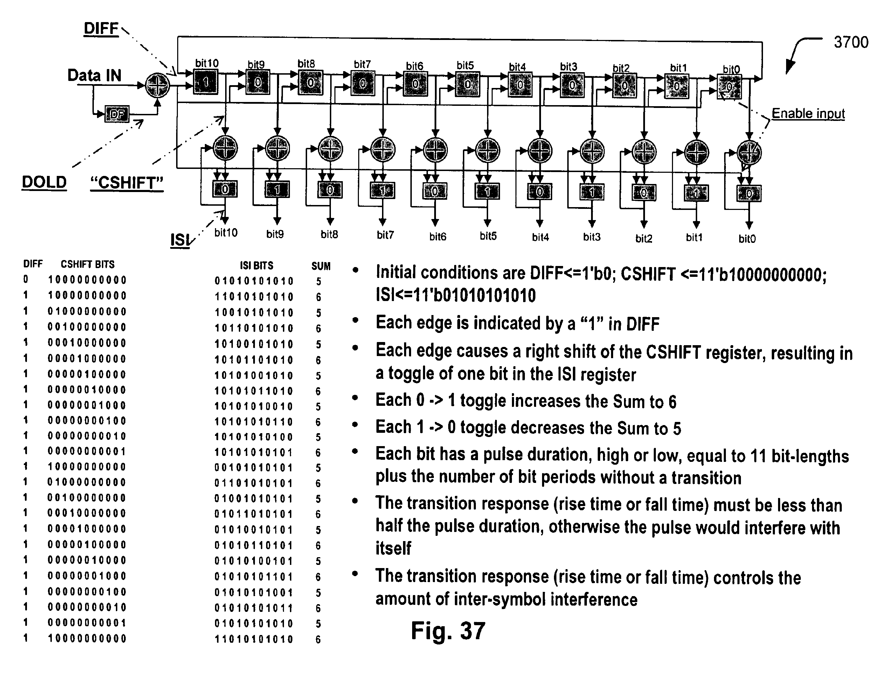

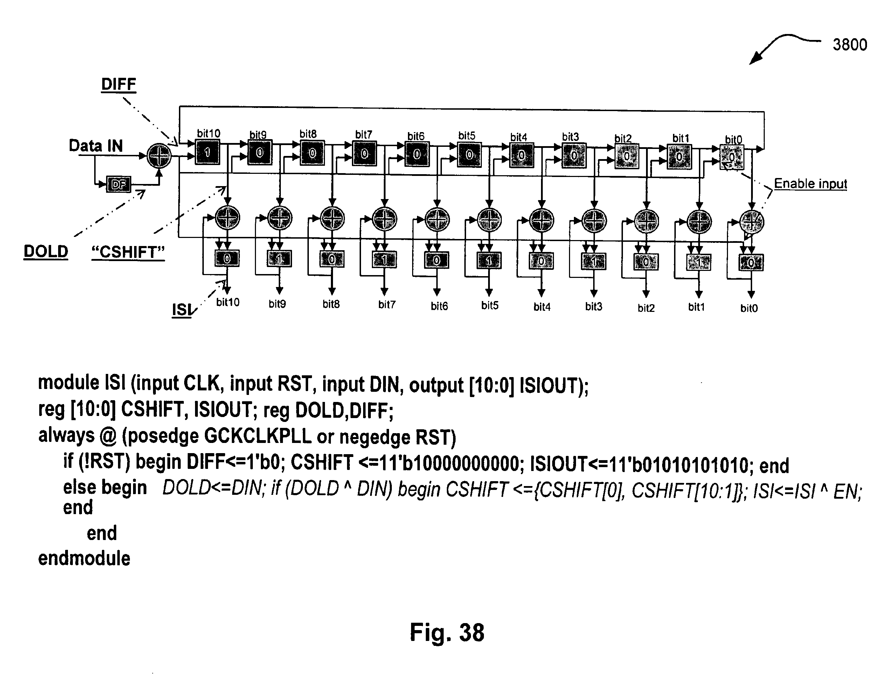

FIG. 37 and FIG. 38 illustrate embodiments 3700 and 3800, respectively, of decomposition of an input stream.

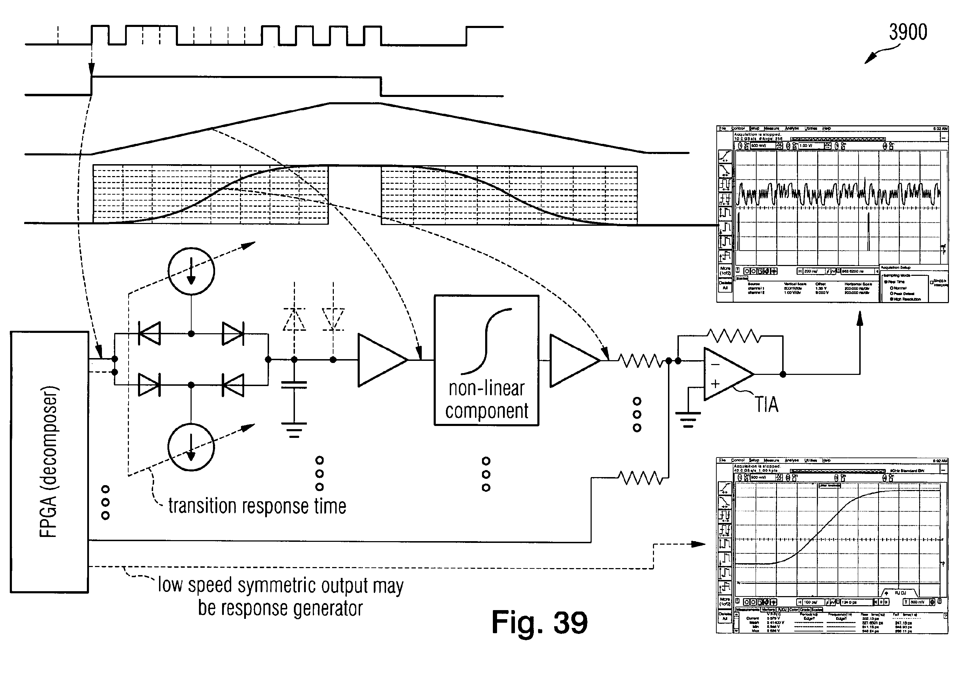

FIG. 39 illustrates an embodiment 3900 of analog transition response generator and sum. An FPGA (decomposer) provides a number of output signals that are each passed through an analogous corresponding network that includes a diode network, that itself includes two current supplies that feed the diode network, whose output values are modified to adjust the transition response time within the virtual disk drive. The output of the diode network is provided to a first buffer, that is preceded by a shunt capacitor to ground (and two diodes, oppositely connected, to a higher voltage, if desired). The output of the first buffer is provided to a non-linear component, whose output is then passed through a second buffer; the output of the second buffer is passed through a resistor that is then connected to the TIA. The TIA can be a THS4304 TIA in some embodiments that provides for an operational bandwidth of 3 GHz. Each of these comparable networks is connected to the TIA via a resistor. As can be seen, the output from the TIA corresponds to the bit stream (indicating each of its transitions) as shown at the top of the diagram. If desired, the low speed symmetric output from the FPGA can be employed as a response generator.

When considering several of the various embodiments and approaches above, certain characterizations can be made.

In a first embodiment, a digital FIR with DAC can provide for a digital speed of 2.3 Giga-samples per second, an analog speed of 1.15 GHz LPF, and the overall size is governed primarily by the FPGA plus the DAC in a parallel FIR implementation. Full programmability is also achieved using this approach.

In a second embodiment, an FIR LUT with DAC can provide for a bit rate of 2.3 GHz/4 (which is approximately 575 Mbps), a digital speed of 2.3 Giga-samples per second, and an analog speed of 1.15 GHz LPF. The overall size is governed primarily by the FPGA plus the DAC. In addition, 4 × 2048 × 12 bit LUTs are also employed. This embodiment also provides for full programmability.

In a third embodiment, a resistor network can provide for a bit rate of 500 Mbps/4 (which is approximately 125 Mbps), a digital speed of 125 MHz × 4 phases, and an analog speed of 2 GHz (as governed primarily by the TIA). The overall size is governed primarily by the FPGA plus the 4 × 80 weighting resistors.

In a fourth embodiment, an analog convolution network can provide for a bit rate of 600 Mbps, a digital speed of 400 MHz/4 (which is approximately a 150 MHz clock), and an analog speed of 600 Mbps/11 (which is approximately 55 M-transitions per line (20 nsec components)). The overall size is governed primarily by the FPGA plus the 11 × analog step function generators.

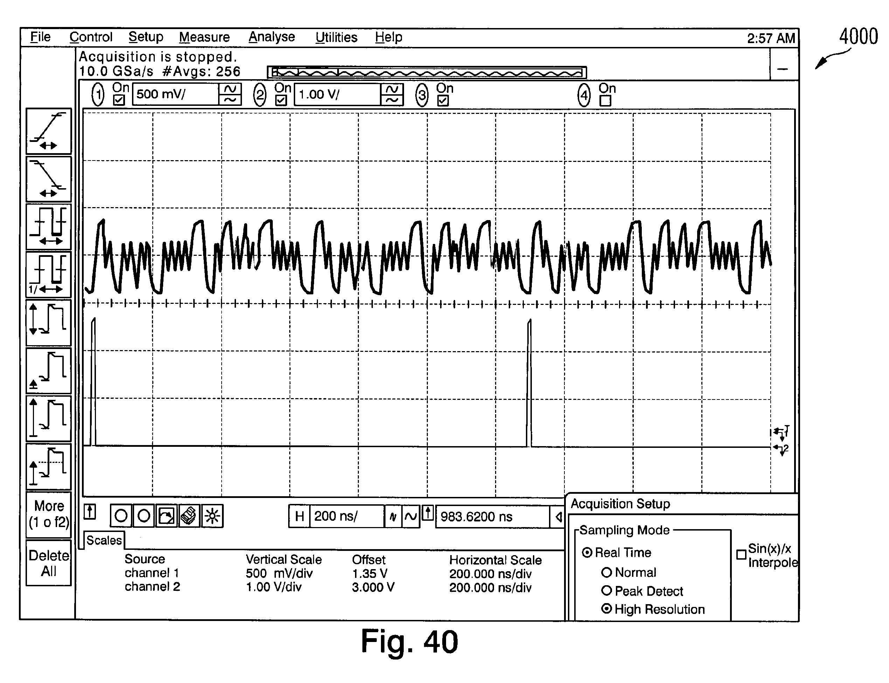

FIG. 40 illustrates an embodiment of test results for the analog transition response generator and sum of FIG. 39. This diagram is an enlarged version of the smaller version of the signal shown as being output from the TIA in FIG. 39.

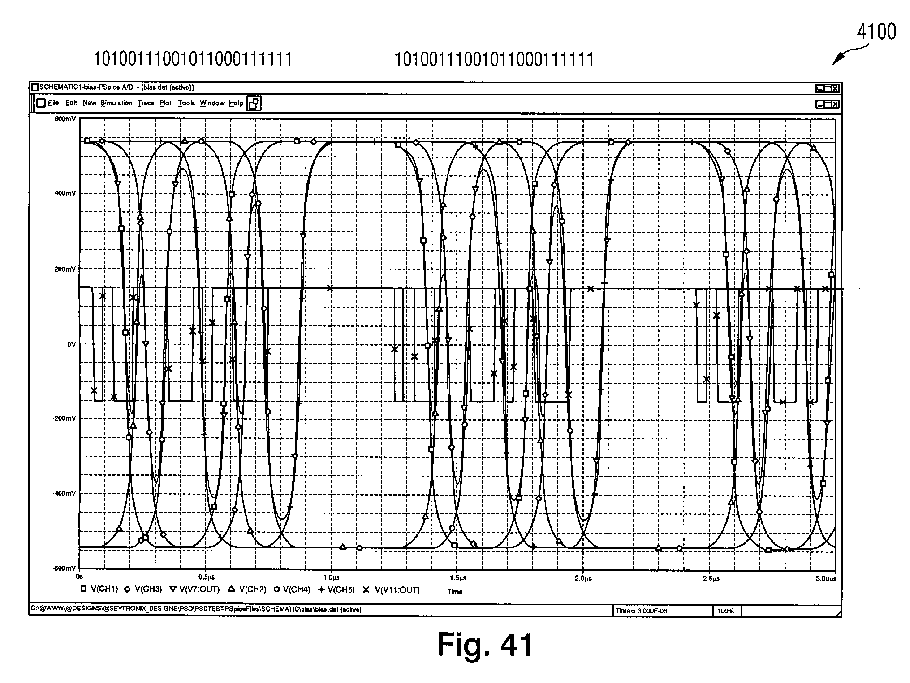

FIG. 41 illustrates an embodiment of a spice simulation for the analog transition response generator and sum of FIG. 39. The simulated diodes have a 5 nsec recovery time, and real diodes can have approximately a 0.1 nsec recovery time. In this simulation, an ideal operational amplifier is used, and a real operational amplifier can have approximately a 3 GHz bandwidth for the -3 db level (i.e., the 3 db corner frequency). The simulated sequence is:10100111001011000111111.

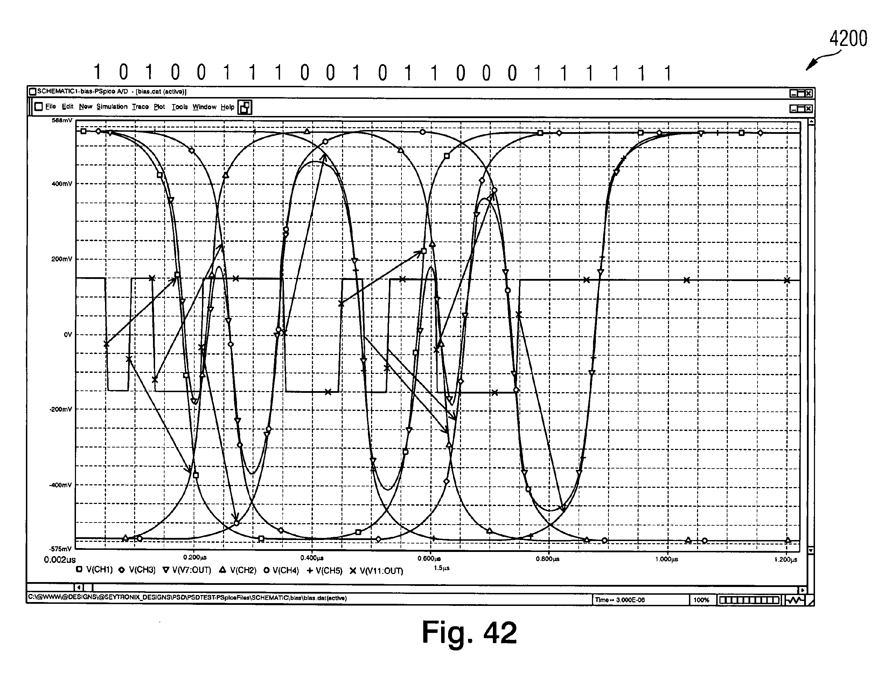

FIG. 42 illustrates an embodiment of rise and fall correspondence after decomposition. This diagram is an enlarged version of the signal transitions shown as within FIG. 41.

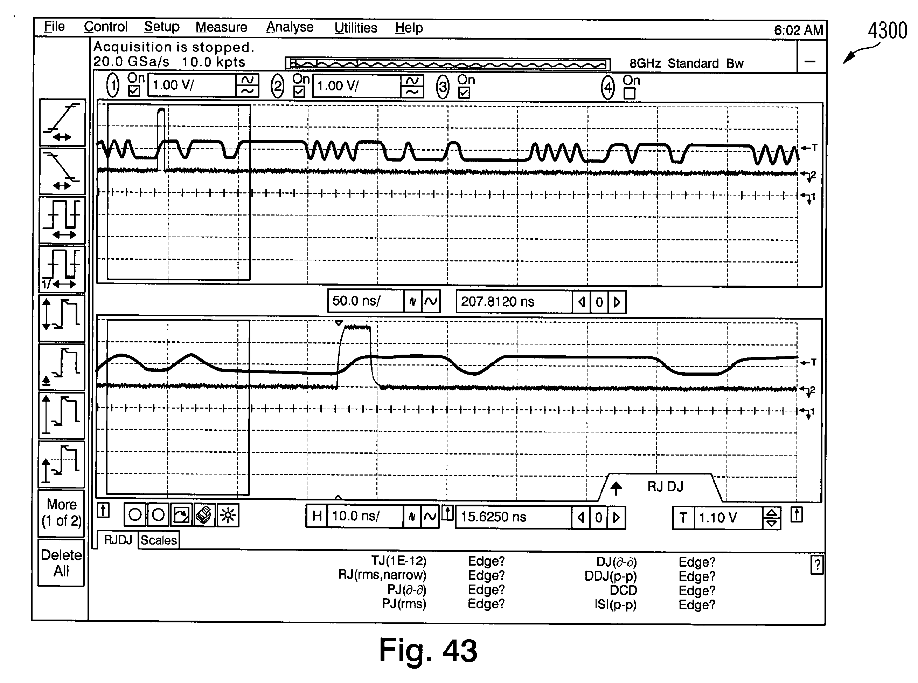

FIG. 43 illustrates another embodiment of test results for the transition response generator and sum of FIG. 39. The bottom portion of the diagram is an enlarged section as selected in the upper left hand side of top of the diagram.

A virtual disk drive, as implemented in accordance with the various aspects depicted herein, provides for a complete design environment in which any of the components within an HDD system can be tested. All or none of the actual components of the HDD system may be available within the virtual disk drive. As certain components within an HDD system may be available (e.g., as integrated circuits and/or other components within the HDD become available), then those integrated circuits and/or components can be implemented within the virtual disk drive so that the virtual disk drive includes some actual integrated circuits and/or components and some simulated integrated circuits and/or components. Such a virtual disk drive allows the development an HDD system to be performed many months prior to the arrival of any one or more of the actual hardware components within such an HDD system. This can be particular beneficial when an HDD system is under development such that the design of which is a relatively substantial departure from prior art and previous HDD systems. In such environments, there may not be a great deal of knowledge of the interaction of the various sub-systems within such a newer HDD system, and a virtual disk drive that allows for great flexibility in the design process can be very desirable.

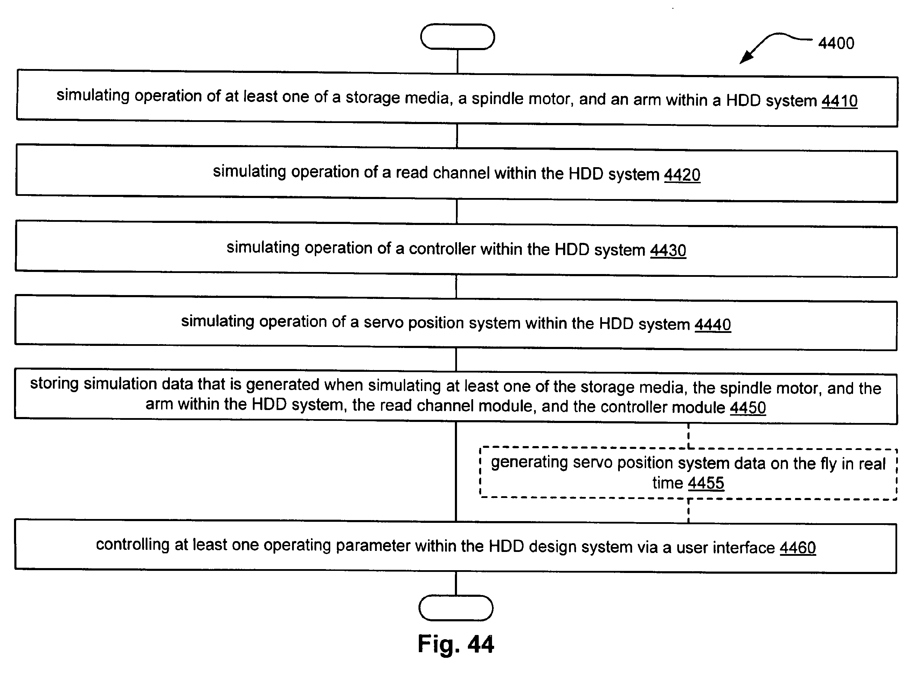

FIG. 44 illustrates an embodiment of a method 4400 for designing an HDD system. As shown in a block 4410, the method 4400 includes simulating operation of at least one of a storage media, a spindle motor, and an arm within a HDD system. The method 4400 continues, as shown in a block 4420, by simulating operation of a read channel within the HDD system. The method 4400 continues, as shown in a block 4430, by simulating operation of a controller within the HDD system. In addition, the method 4400 operates, as shown in a block 4440, by simulating operation of a servo position system within the HDD system.

Including within the method 4400 for designing an HDD system is the storing of simulation data that is generated when simulating at least one of the storage media, the spindle motor, and the arm within the HDD system, the read channel module, and the controller module, as shown in a block 4450. If desired, the method 4400 can also include generating servo position system data on the fly in real time. The method 4400 also includes controlling at least one operating parameter within the HDD design system via a user interface, as shown in a block 4460.

The present invention has also been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope and spirit of the claimed invention.

The present invention has been described above with the aid of functional building blocks illustrating the performance of certain significant functions. The boundaries of these functional building blocks have been arbitrarily defined for convenience of description. Alternate boundaries could be defined as long as the certain significant functions are appropriately performed. Similarly, flow diagram blocks may also have been arbitrarily defined herein to illustrate certain significant functionality. To the extent used, the flow diagram block boundaries and sequence could have been defined otherwise and still perform the certain significant functionality. Such alternate definitions of both functional building blocks and flow diagram blocks and sequences are thus within the scope and spirit of the claimed invention.

One of average skill in the art will also recognize that the functional building blocks, and other illustrative blocks, modules and components herein, can be implemented as illustrated or by discrete components, application specific integrated circuits, processors executing appropriate software and the like or any combination thereof.

Moreover, although described in detail for purposes of clarity and understanding by way of the aforementioned embodiments, the present invention is not limited to such embodiments. It will be obvious to one of average skill in the art that various changes and modifications may be practiced within the spirit and scope of the invention, as limited only by the scope of the appended claims.

## Claims

1. A hard disk drive (HDD) design system, the system comprising:
a VHDA (Virtual Hard Disk Assembly) that is operable to simulate operation of at least one of a storage media, a spindle motor, and an arm within a HDD system;
a read channel module that is operable to simulate operation of a read channel within the HDD system;
a controller module that is operable to simulate operation of a controller within the HDD system;
a servo position module that is operable to simulate operation of a servo position system within the HDD system; and
a user interface that is operable to permit modification of at least one operating parameter within the HDD design system.

2. The system of claim 1, wherein:
the HDD design system is operable to generate servo position system data on the fly in real time.

3. The system of claim 1, wherein:
at least one of the read channel module and the controller module is implemented, at least in part, within the HDD design system using an integrated circuit.

4. The system of claim 1, wherein:
at least one of the VHDA, the read channel module, the controller module, and the servo position module is simulated within the HDD design system using a field programmable gate array (FPGA).

5. The system of claim 1, wherein:
the read channel module is implemented as a read channel integrated circuit within the HDD design system; and
the servo position module is implemented as an actual servo position system within the HDD design system.

6. The system of claim 1, wherein:
the read channel module is implemented as a read channel integrated circuit within the HDD design system;
the controller module is implemented as a controller integrated circuit within the HDD design system; and
the servo position module is implemented as an actual servo position system within the HDD design system.

7. A hard disk drive (HDD) design system, the system comprising:
a VHDA (Virtual Hard Disk Assembly) that is operable to simulate operation of at least one of a storage media, a spindle motor, a preamp, and an arm within a HDD system;
a read channel module that is operable to simulate operation of a read channel within the HDD system;
a controller module that is operable to simulate operation of a controller within the HDD system;
a servo position module that is operable to simulate operation of a servo position system within the HDD system;
a user interface that is operable to permit modification of at least one simulated or actual component within the HDD design system; and
a memory buffer that is operable to store simulation data that is generated by at least one of the VHDA, the read channel module, and the controller module; and
wherein:
at least one of the read channel module and the controller module is implemented, at least in part, within the HDD design system using an integrated circuit; and
the memory buffer is operable to store at least 1 Giga-byte of simulation data.

8. The system of claim 7, wherein:
the HDD design system is operable to generate servo position system data on the fly in real time.

9. A method for designing a hard disk drive (HDD) system, the method comprising:
simulating operation of at least one of a storage media, a spindle motor, and an arm within a HDD system;
simulating operation of a read channel within the HDD system;
simulating operation of a controller within the HDD system;
simulating operation of a servo position system within the HDD system;
storing simulation data that is generated when simulating at least one of the storage media, the spindle motor, and the arm within the HDD system, the read channel module, and the controller module; and
controlling at least one operating parameter within the HDD design system via a user interface.

10. The method of claim 9, further comprising:
generating servo position system data on the fly in real time.
